# NEUE EUROPÄISCHE PATENTSCHRIFT

(11) **EP 0 645 276 B2**
(45) Veröffentlichungstag und Bekanntmachung des Hinweises auf die Entscheidung über den Einspruch: **19.03.2003**
(45) Hinweis auf die Patenterteilung: 20.05.1998
(21) Anmeldenummer: 94105587.3
(22) Anmeldetag: 12.04.1994
(51) Int. Cl.: B60K 37/02

(54) **Kombinations-Instrument**
Combination instrument
Instruments combinés

(30) Priorität: 25.09.1993 DE 4332716
(43) Veröffentlichungstag der Anmeldung: 29.03.1995
(73) Patentinhaber: Mannesmann VDO AG, 60326 Frankfurt (DE)
(72) Erfinder: Simon, Ernst-Ulrich, D-61440 Oberursel (DE); Zech, Stephan, D-65337 Eltville (DE); May, Norbert, D-65934 Frankfurt (DE)
(74) Vertreter: Klein, Thomas, Dipl.-Ing. (FH)

(56) Entgegenhaltungen:
- EP-A- 0 383 740
- EP-A- 0 420 650
- EP-A- 0 499 549
- EP-B- 0 600 152
- DE-A- 3 744 541
- DE-A- 4 206 073
- DE-U- 8 321 864
- GB-A- 2 121 583

## Beschreibung

Die Erfindung bezieht sich auf ein Kombinations-Instrument mit einem Gehäuse, einem Systemträger zur Aufnahme von Anzeigeinstrurnenten und einer Leiterplatte, die mit dem Systemträger mittels Befestigungselementen verbunden ist.

Es ist bereits ein Kombinations-Instrument allgemein bekannt, das aus einem eine Leiterplatte aufweisenden Systemträger mit verschiedenen Anzeigeinstrumenten und Anzeigedisplays besteht. Die einzelnen Teile bestehen teilweise aus starrem Kunststoff und sind über ebenfalls starre Verbindungen miteinander verbunden. Steigt die Außentemperatur oder die Betriebstemperatur des Fahrzeugs sehr stark an, so dehnen sich die Kombinations-Instrumente mit den zugehörigen Anzeigeelementen aus und es kann zu starken Anzeige-Ungenauigkeiten kommen, da beispielsweise die auf der Leiterplatte angeordneten Meßwerke gegenüber den Zifferblättern verschoben werden können.

Ein weiteres Kombinations-Instrument ist aus EP 0 499 549 A1 bekannt. Dieses Instrument weist keine Leiterplatte, aber eine Lichtführung auf, die mit einem Werk versehen sein kann. Die Lichtführung ist an einer Auskragung eines starren Bauteils anliegend fest eingespannt.

Der Erfindung liegt die Überlegung zugrunde, den Systemträger oder die Leiterplatte zur Aufnahme von Instrumenten derart auszubilden, daß auch bei sehr großen Temperaturschwankungen dem Fahrer genaue Meßergebnisse übermittelt werden können.

Die Aufgabe wird dadurch gelöst, daß die Leiterplatte mittels der Befestigungselemente gegenüber dem Systemträger schwimmend gelagert ist und daß die Leiterplatte und/oder der Systemträger in zwei oder mehrere Leiterplatten-Abschnitte bzw. Systemträgerabschnitte aufgeteilt ist, die in mindestens einer Ebene unabhängig voneinander verstellbar sind. Insbesondere hierzu ist es vorteilhaft, wenn sich die einzelnen Leiterplatten-Abschnitte, die mit mindestens einem einzelnen Anzeigeinstrument oder einem einzelnen Display ausgestattet sind, über Verbindungselemente bzw. Tragelemente an Leiterplatten-Abschnitten bzw. an den den Leiterplatten-Abschnitten zugeordneten Teilen abstützen.

Mit der vorteilhaften Ausbildung der Leiterplatte lassen sich auch sehr große Einheiten als Leiterplatte für ein Kombinations-Instrument verwenden, ohne daß zu befürchten ist, daß bei großen Temperaturschwankungen Fehlanzeigen an den Meßinstrumenten auftreten. Durch die Möglichkeit, sehr kleine voneinander getrennte Leiterplatten-Abschnitte nebeneinander anzuordnen, kann eine Vielzahl von Meßinstrumenten bzw. Anzeigedisplays einer sehr großen aus den einzelnen Leiterplatten-Abschnitten gebildeten Leiterplatte zugeordnet werden. Dehnen sich die einzelnen Leiterplatten-Abschnitte aus, so wird durch die vorteilhafte Ausrichtung der einzelnen Öffnungen sichergestellt. daß keine Beeinflussung der Zeigerachse des zugehörigen Instrumentes erfolgt, da die Achsen der Öffnung oder der Schnittpunkt der Achsen identisch ist mit dem Mittelpunkt der ZeigerDurch die Aufteilung in einzelne Leiterplatten-Abschnitte wird es auch auf einfache Weise möglich, die gesamte Leiterplatte mit den einzelnen Leiterplatten-Abschnitten großen Temperaturschwankungen auszusetzen, ohne daß Genauigkeitsänderungen bei der Anzeige auftreten. Die einzelnen Anzeigeelemente, die miteinander in funktionsmäßigem Zusammenhang stehen, können sich durch die vorteilhafte Montage und durch die Unterteilung der Leiterplatten-Abschnitte in verschiedene Abschnitte gegeneinander verschieben, ohne daß Anzeigen verfälscht werden.

Eine zusätzliche Möglichkeit ist gemäß einer Weiterbildung der erfindungsgemäßen Vorrichtung, daß die einzelnen Leiterplatten-Abschnitte über Verbindungselemente bzw. Tragelemente mit benachbarten Leiterplatten-Abschnitten verbunden und unabhängig voneinander gegenüber benachbarten Leiterplatten-Abschnitten und/oder dem Systemträger bzw. Kombigehäuse beweglich sind. Durch die einzelnen Verbindungselemente bzw. Tragelemente wird auf kostengünstige Weise eine einfache Abstützung für die Leiterplatten-Abschnitte gewährleistet und ferner ermöglicht, daß diese sich gegenüber dem Systemträger bzw. anderen Leiterabschnitten verstellen können.

Gemäß einer bevorzugten Ausführungsform der erfindungsgemäßen Lösung ist schließlich vorgesehen, daß die Verbindungselemente bzw. Tragelemente eine gegenseitige Verstellung der Leiterplatten-Abschnitte zulassen.

Von besonderer Bedeutung ist für die vorliegende Erfindung, daß die Verbindungselemente bzw. Tragelemente längenveränderlich bzw. elastisch ausgebildet sind. Dadurch ist eine Verstellung eines Leiterplatten-Abschnitts gegenüber dem benachbarten Leiterplatten-Abschnitt möglich, ohne daß dadurch eine gegenseitige Störung an den Leiterplatten-Abschnitten bzw. den zugehörigen Meßsystemen auftritt. Temperaturschwankungen bzw. selektive Erschütterungen können ebenfalls ausgeglichen werden.

Im Zusammenhang mit der erfindungsgemäßen Ausbildung und Anordnung ist es von Vorteil, daß die Leiterplatte und/oder der Systemträger bzw. das Kombigehäuse einen oder mehrere Ausschnitte aufweisen, in denen die Leiterplatten-Abschnitte und/oder Systemträgerabschnitte eingelassen sind, wobei die Abschnitte zur Aufnahme von Anzeigeelementen und/oder Bedienungselementen dienen.

Gemäß der Erfindung weist die Leiterplatte mehrere Ausschnitte auf, in denen Leiterplatten-Abschnitte schwimmend gelagert sind. Es ist natürlich auch möglich, auf ähnliche Weise den Systemträger auszubilden und mit entsprechenden Systemträgerabschnitten auszustatten, die gegenüber dem Hauptsystemträger schwimmend gelagert sind.

Vorteilhaft ist es ferner, daß die äußeren Begrenzungen der in den Ausschnitten aufgenommenen Leiterplatten-Abschnitte allseitig einen annähernd gleichen Abstand zu der die Ausnehmung bildenden Begrenzung aufweisen.

Außerdem ist es vorteilhaft, daß die in den Ausschnitten aufgenommenen Leiterplatten-Abschnitte über die zahlreichen Verbindungselemente beweglich mit der Leiterplatte verbunden sind und daß die Leiterplatte bzw. die Leiterplatten-Abschnitte Öffnungen aufweisen, die auf einer Ebene angeordnet sind, die den Mittelpunkt eines Anzeigesystems bzw. Anzeigedisplays schneiden.

Ferner ist es vorteilhaft, daß die Leiterplatten-Abschnitte zahlreiche Öffnungen aufweisen, die auf zwei oder mehreren sich in einem Winkel schneidenden Achsen angeordnet sind, die den Meßmittelpunkt des Meßsystems oder deren Zeigerachse bzw. das Anzeigedisplay oder in etwa den Mittelpunkt des Leiterplatten-Abschnitts schneiden. Die Anordnung der einzelnen Öffnungen wird auf diese Weise so gestaltet, daß der Schnittpunkt der Achsen identisch ist mit dem Mittelpunkt der Anzeigeachse oder des Anzeigesystems. Der durch die Löcher bestimmte x-Nullpunkt befindet sich in der Mitte des Anzeigedisplays. Dadurch wird erreicht, daß der Abstand vom x-Nullpunkt zum äußersten Kontaktierungspunkt minimiert wird. Diese Minimierung bewirkt, daß geringe temperaturbedingte Differenzänderungen durch die Kontaktierungselemente aufgefangen werden können.

Eine zusätzliche Möglichkeit ist gemäß einer Weiterbildung der erfindungsgemäßen Vorrichtung, daß das Anzeigesystem bzw. Anzeigedisplay bzw. das Bedienungselement eine Mittelachse aufweist, die senkrecht zu den Öffnungen bzw. parallel zu deren Seitenwänden bzw. der sich durch die Öffnung erstreckenden Achse verläuft.

In weiterer Ausgestaltung der Erfindung ist es vorteilhaft, daß die Öffnungen der Leiterplatten-Abschnitte als Langlochöffnungen ausgebildet sind, deren sich in Längsrichtung der Langlochöffnungen erstreckende Längsmittelachsen den Meßmittelpunkt des Meßsystems schneiden oder sich bei mindestens zwei Meßsystemen durch die beiden Meßmittelpunkte erstrecken. Die einzelnen Langlochöffnungen lassen ohne weiteres eine gegenseitige Verschiebung der Leiterplatten-Abschnitte untereinander und auch gegenüber dem Systemträger zu, ohne daß hierzu besondere Vorkehrungen getroffen werden müssen.

Es ist auch vorteilhaft, daß die Verbindungselemente als elektrisch leitende Verbindungselemente ausgebildet sind, die die Leiterplatten miteinander verbinden und daß der Systemträger oder die Leiterplatten-Abschnitte zur Aufnahme der Meßsysteme über Zapfen in den Langlochöffnungen beweglich aufgenommen sind. Die einzelnen Verbindungselemente gewährleisten eine Signal- und Versorgungsspannungs-Übertragung zwischen den einzelnen Leiterplatten-Elementen.

Um die Montage des Kombinations-Instruments und der einzelnen Leiterplatten-Abschnitte besonders einfach zu gestalten, ist vorgesehen, daß die Zapfen an einer Seite des Systemträgers angeordnet sind und mit der Oberfläche der Seite des Systemträgers einen rechten Winkel bilden.

Von Vorteil ist es ferner, daß die Längsmittelachse zumindest einer im mittleren Bereich der Leiterplatte vorgesehenen Langlochöffnung parallel bzw. in Längsrichtung zur Längsachse der Leiterplatte und die Längsmittelachse zumindest einer weiteren außerhalb des mittleren Bereichs der Leiterplatte vorgesehenen Langlochöffnung parallel bzw. in Längsrichtung zur Querachse der Leiterplatte verläuft und daß die Zapfen in etwa mittig in den Langlochöffnungen verschiebbar aufgenommen sind und zur Aufnahme von Schraubenbolzen dienen, über die die einzelnen Leiterplatten-Abschnitte befestigbar sind.

Ferner ist es vorteilhaft, daß zur Befestigung der Leiterplatte, des Zifferblatts und/oder der Bedienungselemente an der Leiterplatte zusätzliche Langlöcher in der Leiterplatte bzw. im Zifferblatt vorgesehen sind, wobei die Längsausrichtung dieser Langlöcher von einem zentralen Nullpunkt der Leiterplatte bzw. des Zifferblatts zum Mittelpunkt des jeweiligen Langlochs erfolgt, und daß der Nullpunkt der Mittelpunkt des im zentralen Bereich angeordneten, in Querrichtung orientierten Langlochs ist.

In weiterer Ausgestaltung der Erfindung ist es vorteilhaft, daß die Leiterplatte und/oder die Anzeigesysteme senkrecht zur Längserstreckung der Öffnungen beweglich gelagert sind und daß(22) die in Aussparungen aufgenommenen Anzeigesysteme senkrecht zur Längserstreckung der Aussparungen angeordnet sind und über nachgiebige Stege mittel- oder unmittelbar mit dem Systemträger verbunden sind. Durch die vorteilhafte Ausrichtung und Anordnung der einzelnen Langlochöffnungen mit den zugehörigen Zapfen wird auf kostengünstige Weise eine schwimmende Aufnahme der Leiterplatte im Systemträger möglich. Die einzelnen Bedienungselemente sind dabei senkrecht zur Längserstreckung der Ausnehmungen unverschiebbar im Systemträger gelagert, und es sind lediglich die Leiterplatte und die in der Leiterplatten-Ebene vorgesehenen Zifferblätter bzw. Zifferblattebenen relativ zum Systemträger verschiebbar angeordnet. Die schwimmende Lagerung der einzelnen Komponenten im Systemträger, die nicht auf Leiterplatten und Zifferblätter beschränkt ist, kann mittels der Zapfen und den zugehörigen Langlochverbindungen ohne weiteres sichergestellt werden. Die Verbindung der einzelnen Komponenten mit dem Systemträger stellt dabei auch sicher, daß normalerweise eine Bewegung der Komponenten senkrecht zum Systemträger ausgeschlossen ist. Bei einer schwimmenden Lagerung der Leiterplatte im Systemtrager ist darüber hinaus sichergestellt, daß die Kontaktierung von Antriebssystemen und/oder Bedienungselementen mit der Leiterplatte ebenfalls schwimmend erfolgt.

Damit wird auch gewährleistet, daß die unterschiedlichen Ausdehnungskoeffizienten der einzelnen Komponenten bzw. Leiterplatten-Abschnitte ohne weiteres ausgeglichen werden können. Die Langlöcher sind dabei stets so angeordnet, daß bei Ausgleich der Fertigungstoleranzen eine paßgenaue Positionierung der einzelnen Teile gewährleistet ist. Diese paßgenaue Positionierung ist auch bei unterschiedlichen temperaturbedingten Längenausdehnungen der einzelnen Komponenten gewährleistet. Dies wird insbesondere dadurch erreicht, daß die Langlöcher der x- und y-Achse in einem annähernd rechten Winkel angeordnet sind. Das in der y-Achse verlaufende Langloch ist dabei weitgehend in der Mitte der jeweiligen Komponenten angeordnet. Sind die Zapfen Bestandteil des Systemtragers und auf dessen Ober- oder Unterseite vorgesehen, kann eine sehr hohe Positionierungsgenauigkeit insbesondere der Leiterplatte zum Zifferblatt erreicht werden. Die Befestigung der Komponenten am Systemträger kann beispielsweise mittels Schrauben und angeprägter Unterlegscheiben oder angespritzter Nietbolzen erfolgen. Die Befestigung der einzelnen Komponenten auf dem Systemträger erfolgt dabei unabhängig von der gewählten Befestigungsart über Langlöcher in den zu befestigenden Komponenten. Vorteilhafterweise sind sie stets so angeordnet, daß das zu befestigende Anzeigesystem bei temperaturbedingter Längenänderung der Komponenten zueinander in den Langlöchern verschoben werden kann. Dies wird dadurch erreicht, daß die Längsausrichtung der Langlöcher entsprechend einer Geraden von einem Nullpunkt zum Mittelpunkt des jeweiligen Langlochs erfolgt. Der Nullpunkt ist dabei der Schnittpunkt der Längsachsen der zur Positionierung der Komponenten verwendeten Langlöcher. Eine weitere bevorzugte Ausführungsform geht davon aus, daß die Leiterplatte und diejenigen Anzeigesysteme, die verschiebbar sein müssen, um Spannungen auszugleichen, senkrecht zur Längserstreckung der Ausnehmung verschiebbar im Systemträger gelagert sind. Dies kann insbesondere dadurch erfolgen, daß die verschiebbare Leiterplatte und die verschiebbaren Anzeigesysteme in Ausnehmungen gehalten sind, wobei die Ausnehmungen aufweisenden Bauteile des Systemträgers über senkrecht zur Längserstreckung der Ausnehmung nachgiebige Stege im Systemträgerrahmen befestigt sind.

Vorteilhaft ist es auch, daß die Leiterplatte und/oder der Systemträger in zwei oder mehrere Leiterplatten-Abschnitte bzw. Systemträgerabschnitte aufgeteilt sind, die über mindestens ein durchgehendes Verbindungselement miteinander verbunden sind und daß das durchgehende Verbindungselement elastisch bzw. als Folie ausgebildet ist.

Außerdem ist es vorteilhaft, daß das durchgehende Verbindungselement aus einem Material besteht, das stärker bzw. leichter verformbar ist als die mit dem Verbindungselement verbundenen Leiterplatten-Abschnitte und daß 26 das Verbindungselement und der Leiterplatten-Abschnitt aus unterschiedlichen Materialien gebildet sind, so daß zwischen dem Verbindungselement und dem Leiterplatten-Abschnitt eine unterschiedlich große Relativausdehnung besteht.

In weiterer Ausgestaltung der Erfindung ist es vorteilhaft, daß das durchgehende Verbindungselement aus einem Material besteht, das einen größeren Ausdehnungskoeffizienten bzw. eine größere Ausdehnungszahl σ aufweist als der mit dem Verbindungselement verbundene Leiterplatten-Abschnitt und daß das durchgehende und flexibel ausgebildete Verbindungselement als einteilige Platte bzw. als Folie ausgebildet ist, auf der die einzelnen Leiterplatten-Abschnitte bzw. starren Trägerelemente befestigt sind.

Es ist auch vorteilhaft, daß die einzelnen Leiterplatten-Abschnitte bzw. starren Trägerelemente mittels eines Leitklebers fest mit dem Verbindungselement verbunden sind und daß der Leitkleber aus einer Isoliermasse mit leitenden Partikeln besteht, die derart in der Isoliermasse aufgenommen sind, daß eine leitende Verbindung zwischen den beiden zu befestigenden Teilen nur in Druckrichtung der gegeneinander gepreßten Teile hergestellt wird.

Außerdem ist es vorteilhaft, daß die einzelnen Leiterplatten-Abschnitte bzw. starren Trägerelemente auf das Verbindungselement geklebt bzw. auflaminiert sind und daß das Verbindungselement um seine Längsmittelachse und/oder zwischen den zu verbindenden Teilen um seine Querachse in einem bestimmten Winkelbereich verdrehbar ist.

Ferner ist es vorteilhaft, daß das Verbindungselement bei Temperaturschwankungen zwischen den einzelnen Leiterplatten-Abschnitten ausbeulbar ist und daß die Leiterplatte als flexible durchgehende Platte bzw. als Folie ausgebildet ist, die auf mehreren mit Abstand zueinander angeordneten Unterstützungselementen aufgebracht bzw. mit diesen verklebt ist.

Es ist außerdem vorteilhaft, daß die flexible Leiterplatte über als Verbindungselemente ausgebildete Ausgleichsschlaufen mit den Leiterplatten-Abschnitten verbunden und auf dem Kunststoff- bzw. Systemträger montiert ist.

Durch die vorteilhafte Ausgestaltung des flexiblen Verbindungselements, welches als durchgehende bzw. einteilige Platte ausgebildet sein kann, können auf kostengünstige und sehr vorteilhafte Weise die Zeigerantriebssysteme in verschiedenen Winkeln zueinander angeordnet werden.

Vorteilhaft ist ferner, daß die Leiterplatte und/oder der Systemträger in zwei oder mehrere Leiterplatten-Abschnitte bzw. Systemträgerabschnitte aufgeteilt sind, die in mehreren Ebenen unabhängig voneinander verstellbar in der Ebene, quer zur Ebene und/oder schräg zur Ebene der Leiterplatte verstellbar sind.

Vorteilhaft ist es außerdem, daß die Leiterplatten-Abschnitte über eine oder mehrere Sollbruchstellen und über eine oder mehrere Windungen aufweisende Verbindungselemente mit der Leiterplatte verbunden sind.

In weiterer Ausgestaltung der Erfindung ist vorteilhaft, daß die Leiterplatten-Abschnitte über ein oder mehrere meanderförmig verlaufende Verbindungselemente mit der Leiterplatte verbunden sind und daß die Verbindungselemente zwischen den Leiterplatten-Abschnitten und der Leiterplatte als elektrisch leitende und/oder als elektrisch nicht leitende Verbindungselemente ausgebildet sind.

Vorteilhaft ist es außerdem, daß die Leiterplatten-Abschnitte rechteckförmig oder quadratisch ausgebildet sind und jede Stirnkante bzw. der an die Stirnkante angrenzende Bereich des Leiterplatten-Abschnitts innerhalb der den Leiterplatten-Abschnitt aufnehmenden Aussparung der Leiterplatte über ein oder zwei Verbindungselemente mit der Leiterplatte beweglich verbunden ist und daß jedem Verbindungselement eine Sollbruchstelle zugeordnet ist.

Ferner ist es vorteilhaft, daß jede Stirnkante des Leiterplatten-Abschnitts über die Sollbruchstelle mit der parallel zur Stirnkante des Leiterplatten-Abschnitts verlaufenden Stirnkante der Aussparung verbunden ist und daß bei großer Wärmeausdehnung jeweils die beiden gegenüberliegenden Sollbruchstellen gelöst werden und sich der Leiterplatten-Abschnitt um die Achse der beiden verbleibenden, gegenüberliegenden Sollbruchstellen neigt.

Durch die vorteilhafte Ausbildung der Leiterplatten-Abschnitte innerhalb der entsprechenden Aussparung der Leiterplatte und die vorteilhafte Ausgestaltung der einzelnen Verbindungselemente kann sich die Leiterplatte in jede beliebige Richtung und Ebene gegenüber der Leiterplatte verstellen, wenn aufgrund von hohen Temperaturen und der damit verbundenen Wärmeausdehnung ein derartiges Verstellen des Leiterplatten-Abschnitts erforderlich wird. Die meanderförmig verlaufenden Verbindungselemente sind gleichzeitig die stromführenden Elemente bzw. Leiterfahnen, die derart stark ausgebildet sind, daß sie gleichzeitig als Tragelemente fungieren können. Es ist natürlich auch möglich, neben den Verbindungselementen nichtleitende Verbindungselemente vorzusehen. Darüberhinaus können die Leiterplatten-Abschnitte bei der Montage über sollbruchstellenartige Verbindungselemente mit der Leiterplatte fest verbunden werden, so daß bis zur endgültigen Montage der Leiterplatten-Abschnitt seine Lage in der gleichen Ebene beibehält wie die Leiterplatte. Nach der Montage lassen sich die Sollbruchstellen lösen. Es ist jedoch auch möglich, daß derartige Sollbruchstellen durch übergroße Wärmeausdehnung brechen, so daß danach eine Neigung bzw. Schwenkung des Leiterplatten-Abschnitts um die Achse der verbleibenden sollbruchartigen Verbindungselemente erfolgt.

Weitere Vorteile und Einzelheiten der Erfindung sind in den Patentansprüchen und in der Beschreibung erläutert und in den Figuren dargestellt, wobei bemerkt wird, daß alle Einzelmerkmale und alle Kombinationen von Einzelmerkmalen erfindungswesentlich sind. Es zeigt:
- Figur 1: eine Explosionsdarstellung eines Kombinations-Instruments mit der in ein Gehäuse einbaubaren Leiterplatte, auf der zahlreiche Anzeigekomponenten bzw. Lichtquellen vorgesehen sind,
- Figur 2: eine Draufsicht einer verschiedene Ausschnitte aufweisenden Leiterplatte,
- Figur 3: eine Explosionsdarstellung des Kombinations-Instruments mit der in ein Gehäuse einbaubaren Leiterplatte sowie die zugehörigen Anzeigesysteme,
- Figur 4: eine Draufsicht einer verschiedene Ausschnitte aufweisenden Leiterplatte zur Aufnahme von Anzeigedisplays, wobei die einzelnen Abschnitte über elektrische Verbindungselemente miteinander verbunden sind,
- Figur 5: eine Draufsicht des Ausführungsbeispiels gemäß Fig. 6,
- Figur 6: eine zweite Ausführungsform des Systemträgers im Schnitt,
- Figur 7: die Leiterplatte gemäß Fig. 8, jedoch mit zahlreichen Langlochöffnungen, die auf sich schneidenden Achsen angeordnet sind,
- Figur 8: ein weiteres Ausführungsbeispiel einer flexiblen, durchgehenden Leiterplatte, die auf mehreren, mit Abstand zueinander angeordneten Unterstützungselementen angeordnet ist,
- Figur 9: ein weiteres Ausführungsbeispiel zweier mit Abstand zueinander angeordneten Leiterplatten-Abschnitte, die über eine Folie miteinander verbunden sind,
- Figur 10: ein weiteres Ausführungsbeispiel einer Leiterplatte mit in sämtlichen Ebenen beweglich gelagerten Leiterplatten-Abschnitten in Draufsicht,
- Figur 11: eine Schnittdarstellung entlang der Linie A-B gemäß Figur 10.

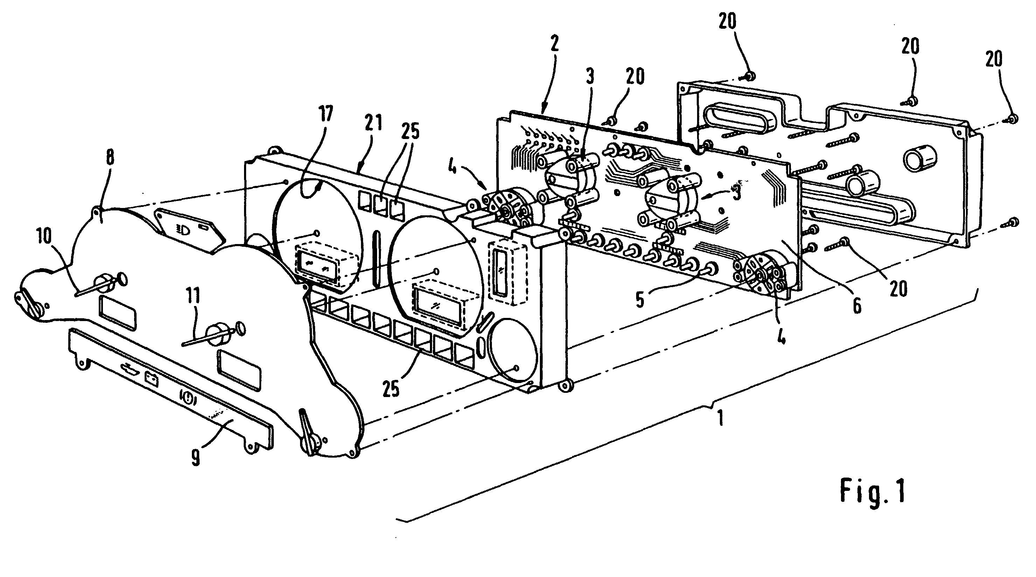

In der Zeichnung ist in Figur 1 mit 1 ein Kombinations-Instrument bezeichnet, das in dieser Figur in einer Explosionsdarstellung wiedergegeben ist. Die einzelnen Teile des Kombinations-Instruments können über Verbindungselemente bzw. Schraubenbolzen 20 miteinander verbunden werden.

Das Kombinations-Instrument 1 weist einen Systemträger bzw. ein Kömbigehäuse 21 auf, in dem zahlreiche nebeneinander angeordnete Ausnehmungen bzw. Öffnungen 17 zur Aufnahme von Anzeigeelementen bzw. Meßwerken 3, 4, 5 vorgesehen sind. Mit Bezug auf Figur 1 befindet sich hinter dem Systemträger 21 ein Anzeigesystem 2, auf dem die zahlreichen Meßwerke 3 und 4 und/oder die Anzeigekomponenten 5 bzw. für Lichtquellen vorgesehene Lichtschächte 25 angeordnet sind. Weitere Bedienungselemente, beispielsweise Laufwerke, LCD-Anzeigevorrichtungen, Einzelteile von Anzeigevorrichtungen, Leitgummi, Streu- und Farbscheiben, Lichtführungsteile sowie Schaltmatten und Stößel, die im Zusammenhang mit dem Kombinations-Instrument von Bedeutung sind, sind im einzelnen nicht weiter veranschaulicht und der Einfachheit halber weggelassen.

Das Anzeigesystem 2 bzw. eine zugehörige Leiterplatte 6 wird von hinten in das kastenförmig ausgebildete Kombigehäuse 21 eingesetzt und anschließend mit dem Systemträger bzw. dem Kombigehäuse 21 lösbar verbunden.

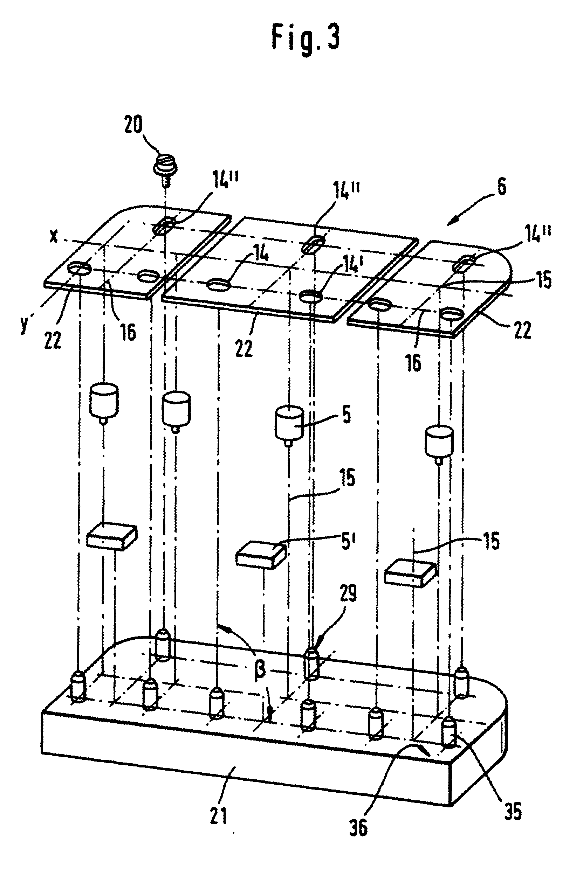

Die Verbindung zwischen der Leiterplatte 6 und dem Kombigehäuse 21 erfolgt über Steckverbindungen, insbesondere über die Befestigungselemente oder Schraubenbolzen 20, die hierzu in entsprechende Montageöffnungen bzw. Gewindebohrungen 29 (Fig. 3) eingeführt werden.

Wie aus Figur 1 hervorgeht, kann auf der Vorderseite des Kombigehäuses 21 ein einteiliges Zifferblatt 8 und, falls erwünscht, eine Blende 9 befestigt werden. Die Befestigung des Zifferblattes 8 auf dem Kombigehäuse 21 erfolgt ebenfalls über nicht dargestellte Schraubenbolzen.

Auf der Vorderseite des Kombigehäuses 21 können ferner Symbolscheiben aufgebracht und mit dieser fest verbunden werden. Nach der Montage der Leiterplatte 6 lassen sich auf den Wellen der Meßwerke 3 und 4 Zeiger 10 und 11 montieren. Die somit zusammengebaute Einheit des Kombinations-Instruments 1 läßt sich dann ohne weiteres in einen in der Zeichnung der Einfachheit halber nicht dargestellten Frontrahmen des Kombinations-Instruments einsetzen und dort sichern. Hierzu dienen in der Zeichnung nicht dargestellte Verbindungselemente bzw. Filmscharniere, die den Frontrahmen mit einem in der Zeichnung nicht dargestellten Lichtkasten zur Aufnahme von Beleuchtungskörpern in Verbindung bringen. Die Stromversorgung der Beleuchtungskörper erfolgt über in der Zeichnung nicht weiter dargestellte elektrische Anschlüsse, die mit der Leiterplatte in Verbindung stehen. Der Frontrahmen kann über ein entsprechendes Deckglas verschlossen werden. Nach entsprechender Einpaßarbeit des Kombigehäuses 21 mit den zugehörigen Komponenten ist der Montagevorgang abgeschlossen.

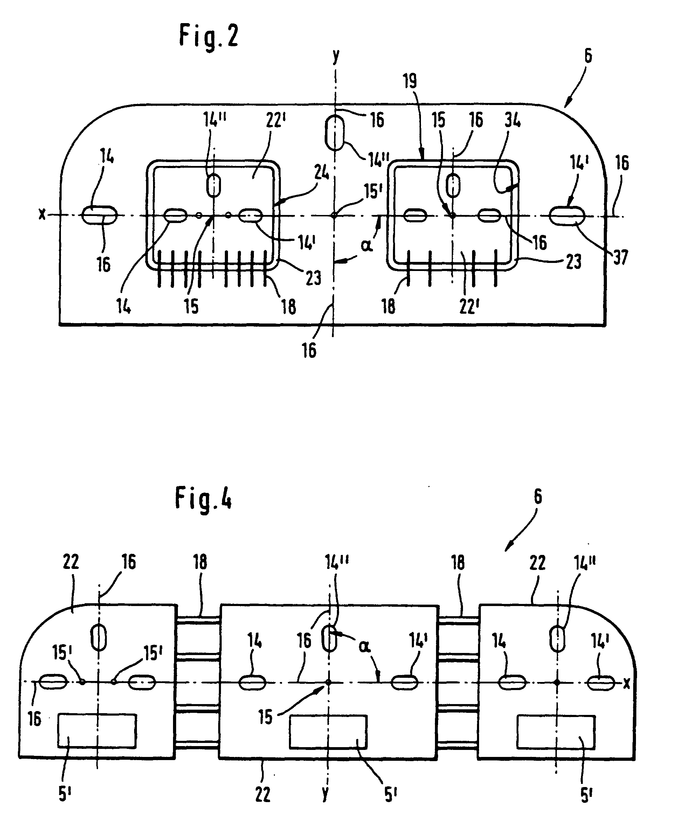

In Figur 2 ist ein erstes Ausführungsbeispiel der erfindungsgemäßen Leiterplatte 6 dargestellt, die, wie bereits erwähnt, über die Befestigungselemente bzw. Schrauben 20 mit dem Systemträger bzw. Kombigehäuse 21 zur Aufnahme von Zeigern oder anderen Anzeigeelementen verbunden werden kann.

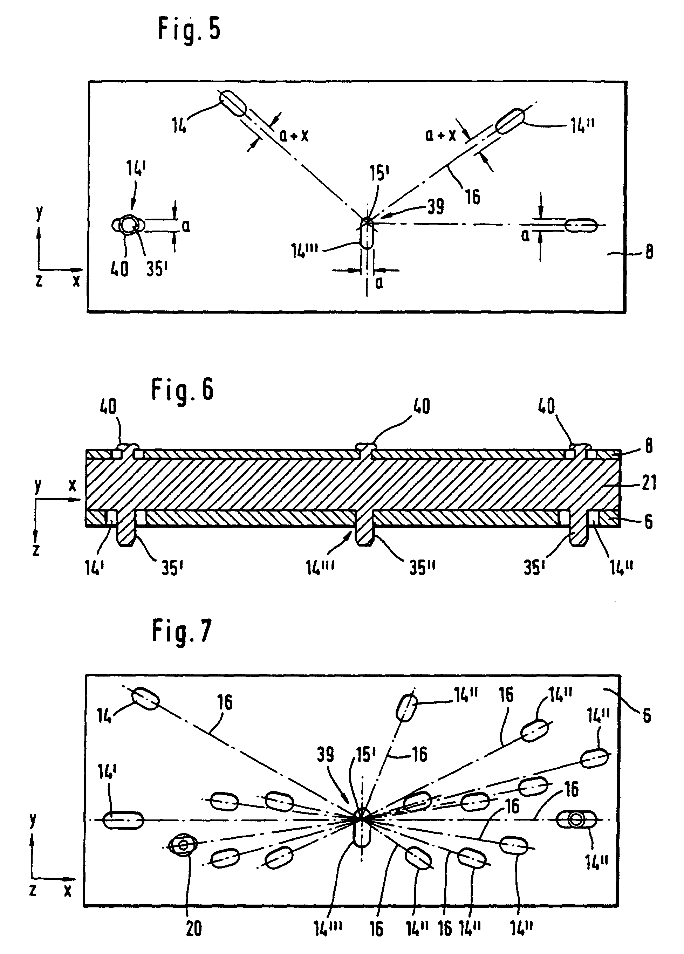

Die eine gegenseitige Bewegung zulassende Verbindung zwischen dem Systemträger 21 und der mit dem Systemträger verbundenen Leiterplatte 6 ist in der Explosionsdarstellung gemäß Figur 3 veranschaulicht. Der Systemträger 21 weist, wie aus Figur 3 hervorgeht, zahlreiche mit gleichmäßigem Abstand untereinander angeordnete, auf einer Oberfläche 36 des Systemträgers 21 angeordnete Zapfen 35 mit Gewindebohrungen 29 auf, die Teil der Befestigungselemente zur Verbindung des Systemträgers 21 mit der Leiterplatte 6 sind. Die Zapfen 35 sind senkrecht auf der Oberfläche 36 des Systemträgers 21 angeordnet, so daß die Längsmittelachse des Zapfens 35 mit der Oberfläche 36 einen rechten Winkel β bildet. Die auf der Oberfläche 36 des Systemträgers 21 angeordneten Zapfen 35 erstrecken sich in eingebautem Zustand der Leiterplatte 6 durch entsprechende Langlochöffnungen 14 bis 14"'(vergl. auch Fig. 5,7), die den gleichen Abstand untereinander aufweisen wie die Zapfen 35 und, wie bereits erwähnt, zu diesen ausgerichtet sind, so daß zumindest ein Teil der Zapfen 35 in diesen Langlochöffnungen 14 bis 14''' beweglich aufgenommen werden kann. Ist also die Leiterplatte 6 auf die Zapfen 35 aufgesteckt, so können die entsprechenden Befestigungselemente bzw. Schrauben 20 in die in den Zapfen 35 vorgesehene Gewindebohrung 29 eingeschraubt werden und sichern damit die Leiterplatte 6 an dem Systemträger 21. In der Zeichnung nicht dargestellte Unterlegscheiben, deren Außendurchmesser größer ist als die längste Ausdehnung der Langlöcher 14 bis 14''', können zwischen der Unterseite des Schraubenkopfs des Schraubenbolzens 20 und der Oberfläche der Leiterplatte 6 vorgesehen werden, so daß eine Relativbewegung zwischen der Leiterplatte 6 und dem Systemträger 21 möglich ist. Die Verstellung der Leiterplatte 6 erfolgt dabei parallel zur Oberfläche 36 des Systemträgers 21 (vergl. Fig. 2, 3, 4, 5,7).

Je nach Ausführungsform ist es auch möglich, die Leiterplatte 6 auf dem Bolzen 20 in Richtung der Oberfläche 36 des Systemträgers 21 bzw. entgegengesetzt dazu zu verstellen.

Wie aus Figur 3, 4 hervorgeht, besteht die Leiterplatte 6 aus drei mit Abstand zueinander angeordneten Leiterplatten-Abschnitten 22, in denen jeweils die drei mit Abstand zueinander angeordneten Langlochöffnungen 14 bis 14" vorgesehen sind. Je nach Größe der Gesamtleiterplatte können zwei oder mehrere, also auch mehr als drei, Leiterplatten-Abschnitte eine Gesamtleiterplatte bilden.

Die einzelnen Langlochöffnungen 14 bis 14" verlaufen auf geradlinigen Achsen 16. Im Ausführungsbeispiel gemäß Figur 3 sind zwei Langlochöffnungen 14 und 14' auf der Achse 16 (x-Richtung) vorgesehen, die parallel zur Längsseite der Leiterplatte 6 verläuft. Die dritte Langlochöffnung 14" befindet sich ebenfalls auf der Achse 16 (y-Richtung), die die Achse 16 (x-Richtung) in einem rechten Winkel α schneidet.

Auf diese Weise kann sich der eine Leiterplatten-Abschnitt 22 gegenüber dem benachbarten Leiterplatten-Abschnitt sowie gegenüber dem Systemträger 21 verstellen, ohne daß sich die Leiterplatten-Abschnitte hierbei berühren. Damit können auch sehr große Temperaturschwankungen und die damit verbundenen Größenveränderungen der einzelnen Leiterplatten-Abschnitte 22 ausgeglichen werden, d. h. die Leiterplatten-Abschnitte 22 können sich ausdehnen und zusammenziehen, ohne daß es dabei zu Verwerfungen der Leiterplatte 6 kommt. Ferner wird durch die vorteilhafte Auswahl der Langlochöffnungen 14 und deren Anordnung auf der Oberfläche der Leiterplatte 6 sichergestellt, daß sich das zugehörige Anzeigeelement gegenüber dem Zifferblatt nicht verschiebt. Hierzu ist es vorteilhaft, wenn zumindest eine Achse 16 einer Langlochöffnung 14 einen Meßmittelpunkt 15, 15' schneidet bzw. wenn nur drei Langlochöffnungen vorgesehen sind, zwei davon auf einer gemeinsamen Achse liegen, die die Achse 16 eines weiteren rechtwinklig dazu angeordneten Langlochs in einem Winkel α von 90° schneidet (vgl. Figur 3).

Das Ausführungsbeispiel gemäß Figur 4, das sich nur geringfügig vom Ausführungsbeispiel gemäß Figur 3 unterscheidet, zeigt ebenfalls die drei mit Abstand zueinander angeordneten Leiterplatten-Abschnitte 22, die über elektrische Verbindungselemente 18 miteinander verbunden sind, die entweder längenveränderlich oder elastisch ausgebildet sein können und zur Signalund Energieübertragung zwischen den einzelnen Leiterplatten-Abschnitten 22 dienen. Die einzelnen Segmente oder partiell entkoppelten Leiterplatten-Abschnitte 22 werden mechanisch über die im rechten Winkel angeordneten Langlochöffnungen 14 bis 14" mit den auf dem Systemträger 21 vorgesehenen Zapfen 35 verbunden, die hierzu mit den entsprechenden Gewindebohrungen 29 zur Aufnahme der Befestigungselemente 20 ausgestattet sind. Die auf den Achsen 16 angeordneten Langlochöffnungen 14 bis 14" schneiden sich in dem Winkel α von 90°. Der Schnitt- oder Meßmittelpunkt 15 der Achsen 16 des mittleren Leiterplatten-Abschnitts 22 entspricht dem x-Nullpunkt 39, der auch dem Schnitt- bzw. Meßmittelpunkt 15 des Meßwerks oder der Anzeigekomponente 5 entspricht. Dadurch wird erreicht, daß der Abstand vom äußersten Kontaktierungspunkt zum x-Nullpunkt 39 minimiert wird. Diese Minimierung bewirkt, daß die geringfügigen temperaturbedingten Differenzlängen-Änderungen durch die Kontaktierungselemente aufgefangen werden können.

Es ist auch möglich, daß gemäß Fig. 4 die beiden sich schneidenden Achsen 16 des rechten oder linken Leiterplatten-Abschnitts 22 den Mittelpunkt 15 bilden, und daß die beiden Meßmittelpunkte 15' von zwei Meßwerken beiderseits des Mittelpunktes 15 symmetrisch angeordnet sind.

Im Ausführungsbeispiel gemäß Figur 2 weist die Leiterplatte 6 zwei Ausnehmungen bzw. Ausschnitte 23 mit Innenkanten 19 auf, die durch eine innere Begrenzung 34 definiert sind. Die rechteckförmige Aussparung 23 dient zur Aufnahme je eines Leiterplatten-Abschnitts 22', der ebenfalls mit zwei auf der Achse 16 angeordneten Langlochöffnungen 14, 14' ausgestattet ist. Die Achse 16 schneidet ebenfalls eine rechtwinklig dazu angeordnete weitere Achse 16, auf der nur eine Langlochöffnung 14" verläuft. Die beiden Achsen 16 schneiden sich im Meßmittelpunkt 15. Die Leiterplatten-Abschnitte 22 sind wiederum über die elektrisch leitenden, elastisch ausgebildeten Verbindungselemente 18 mit dem übrigen Teil der Leiterplatte 6 verbunden.

Die Leiterplatte 6 kann auch drei Langlochöffnungen 14 bis 14" aufweisen, die ebenfalls auf den rechtwinklig zueinander ausgerichteten Achsen 16 angeordnet sind, die sich in einem Mittelpunkt 15' der Leiterplatte 6 schneiden. Durch die vorteilhafte Entkoppelung der Leiterplatten-Abschnitte 22, die zur Aufnahme der LCD-Anzeigen dienen, können Änderungen in der Betriebstemperatur zwischen Anzeigedisplay und Kontaktierungseinrichtung ohne weiteres ausgeglichen werden, da eventuell auftretende Verspannungen der Leiterplatte 6 keinen Einfluß auf die Leiterplatten-Abschnitte 22 haben. Somit wird die Funktionsfähigkeit der Anzeigekomponente bzw. des Anzeigedisplays 5' aufrechterhalten. Der Abstand zwischen einer inneren Begrenzung 24 des Leiterplatten-Abschnitts 22 und der Begrenzung 34 des Ausschnitts 23 bietet hierzu genügend Spielraum.

In den Figuren 5 bis 7 sind zwei weitere Ausführungsbeispiele der Leiterplatte 6 dargestellt, die mittels der zahlreich angeordneten Langlochöffnungen 14' bis 14''' mit dem Systemträger 21 verbunden ist.

In Figur 6 und 7 ist gezeigt, daß der Systemträger 21 benachbart zu seinen Schmalseiten im Bereich der Schmalseitenmitten zwei Zapfen 35' aufweist, ferner in Abstand zur unteren Längsseite im Bereich der Längsseitenmitten einen weiteren Zapfen 35". Die Zapfen 35' und 35" stehen über die rückseitige Oberfläche des Systemträgers 21 hinaus und greifen in die in Figur 7 gezeigten Langlochöffnungen 14 bis 14"' der Leiterplatte 6 ein. Die mit den Zapfen 35' korrespondierenden Langlochöffnungen 14, 14' der Leiterplatte 6 verlaufen in Längsrichtung der Leiterplatte 6, die mit dem Zapfen 35" korrespondierende Schlitzausnehmung 14"' in deren Querrichtung. Aufgrund der unterschiedlichen Wärmeausdehnungskoeffizienten der Leiterplatte 6 und des Systemträgers 21 ist somit eine Relativbewegung des Systemträgers 21 gegenüber der Leiterplatte 6 in x-und y-Richtung möglich, konkret im Bereich der Zapfen 35' und 35".

Damit die Leiterplatte 6 mit dem Systemträger 21 leitend verbunden werden kann und außerdem eine relative Bewegung zwischen Leiterplatte 6 und den zugehörigen Anzeigesystemen und den Bedienungselementen möglich ist, sind in der Leiterplatte 6 die bereits erläuterten Langlochöffnungen 14" vorgesehen. Diese stehen in vorteilhafter Weise mit im Bereich der Anzeigesysteme nicht dargestellten Bedienungselementen in Verbindung, wobei sich sämtliche Längsachsen 16 der Langlöcher 14 bis 14" radial vom Nullpunkt 15' divergierend und radial nach außen erstrecken. Die Befestigung der Leiterplatte 6 am Systemträger 21 kann durch Verschrauben oder Vernieten erfolgen.

Wie aus Figur 7 hervorgeht, ist die Schraube 20, die in dem Langloch 14 der Leiterplatte 6 eingeführt ist, in den Systemträger 21 eingeschraubt. Der Schraubenkopf der Schraube 20 hält die Leiterplatte 6 in der in Figur 7 verdeutlichten z-Richtung, d. h. in einer Richtung senkrecht zur Plattenebene, während eine Verschiebung der Leiterplatte 6 in der Ebene x-y nach wie vor möglich ist. Weitere Schrauben bzw. Nietverbindungen zum Fixieren der Leiterplatte 6 am Systemträger 21 können ebenfalls verwendet werden.

Die Leiterplatte 6 ist nicht nur zum elektrischen Kontaktieren der Anzeigesysteme und Bedienungselemente vorgesehen, sondern hält auch Bauteile in z-Richtung. Damit die Leiterplatte 6 am Systemträger 21 relativ beweglich ist, weisen alle Langlöcher 14 bis 14"' eine Breitenabmessung auf, die um das mögliche Wärmedehnungsspiel in x- und y-Richtung größer ist als der Gewindeabschnitt der jeweiligen Schraube bzw. des jeweiligen Zapfens.

Die für die Schrauben vorgesehenen Unterlegscheiben sind so groß ausgelegt, daß sie die jeweilige Langlochöffnungen 14 bis 14"' überlappen.

Wie aus Figur 6 ferner hervorgeht, weist der Systemträger 21 auf der der Leiterplatte 6 abgewandten Seite die Zapfen 35' und 35" auf, die in den Langlochöffnungen 14' bis 14"' aufgenommen werden können. Die Langlöcher 14' verlaufen in x-Richtung, während die Langlöcher 14" in y-Richtung verlaufen. In der Zeichnung ist mit 40 eine kalt-, warm- oder ultraschallverstemmte Erweiterung im Bereich des Zapfens 35' gezeigt, d. h. das Zifferblatt 8 ist mit dem Systemträger 21 kalt-, warm- oder ultraschallverstemmt. Wie aus Figur 5 hervorgeht, beträgt die Breitenerstreckung der Langlöcher 14' das Maß a+x, um den Dehnungsausgleich zu ermöglichen. Die Längsachsen der Langlöcher 14 bis 14" im Zifferblatt 8 sind so orientiert, daß sie sich alle im Punkt 15' bzw. in der Schnittlinie der Längsachsen 16 der Langlöcher 14 bis 14"' schneiden (vgl. Figur 7).

Es ist auch möglich, daß abweichend von den bisherigen Ausführungsbeispielen die einzelnen Verbindungselemente 18 zwischen den Leiterplatten 22 als eine einzige durchgehende flexible Folie 15 bzw. 18' ausgebildet sind, die auf Leiterplatten-Segmenten bzw. Unterstützungselementen 38 beispielsweise mittels eines Klebers fest verbunden ist. Auf der Leiterplatte 6 befinden sich die verschiedenen elektronischen Bausteine bzw. Meßelemente.

Anstelle einer Verklebung oder Verlötung der flexiblen Folie mit den Leiterplatten-Segmenten 38 ist es auch möglich, diese zu verklemmen oder über Federelemente zu befestigen.

Hierzu ist es möglich, die Leiterplatte 6 selbst flexibel auszubilden und mit den Unterstützungssegmenten bzw. Platten fest zu verbinden bzw. auf diese aufzukleben. Dadurch besteht die Möglichkeit, die einzelnen Zeigerantriebssysteme in verschiedenen Ebenen zueinander anzuordnen.

Das durchgehende Verbindungselement 18 bzw. die Folie 18' kann aus einem Material bestehen, das stärker bzw. wesentlich leichter verformbar ist als die mit den Verbindungselement 18 verbundenen Leiterplatten-Abschnitte 22. Da das Verbindungselement 18 und die Leiterplatten-Abschnitte 22 aus unterschiedlichen Materialien gebildet sein können, erhält man auch eine unterschiedlich große Relativausdehnung der miteinander verbundenen Teile. Zur Verbindung der einzelnen Teile miteinander kann ein Leitkleber 37 eingesetzt werden, in dem leitende Partikel aufgenommen sind, die derart in den Kleber eingebracht sind, daß eine leitende Verbindung zwischen den beiden zu befestigenden Teilen nur in Druckrichtung der gegeneinander gepreßten Teile hergestellt wird. Um die einzelnen Zeiger-Antriebssysteme in verschiedenen Winkeln zueinander anzuordnen, kann das Verbindungselement bzw. die Folie 18' um ihre Längsmittelachse und/oder zwischen den zu verbindenden Teilen um eine Querachse in bestimmten Winkelbereichen verdrehbar sein.

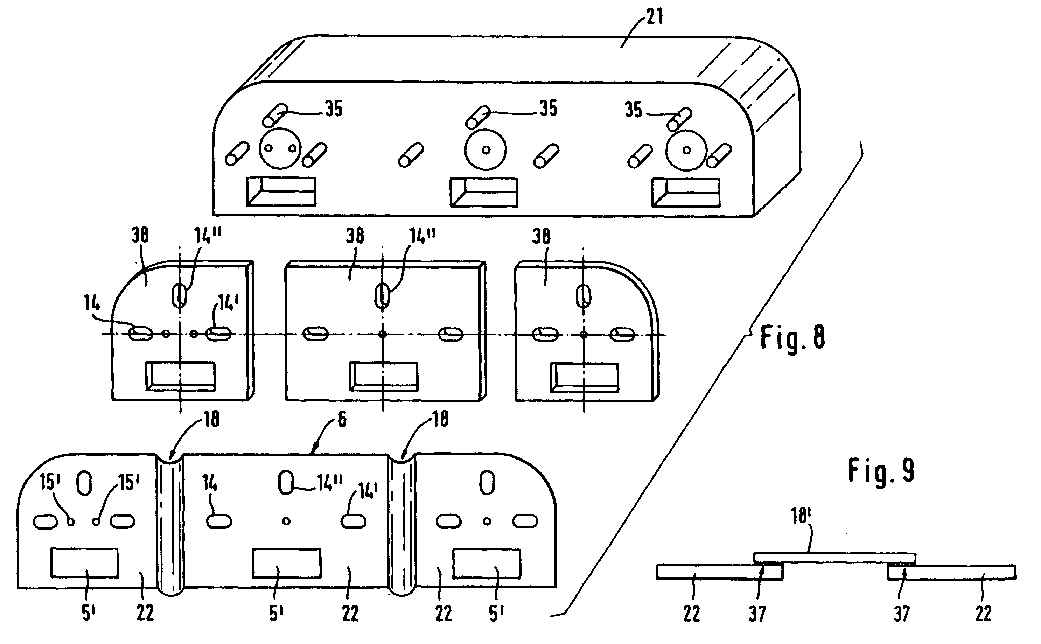

Im Aufführungsbeispiel gemäß Figur 8 können die einzelnen Leiterplattensegmente 38 auch über die als Verbindungselement 18 ausgebildete Ausgleichsschlaufe miteinander verbunden sein, die, wie bereits ausgeführt, auf Leiterplattensegmenten bzw. Unterstützungselementen 38, ähnlich wie bei den anderen Ausführungsbeispielen, montiert sind. Die flexible Leiterplatte 6 bzw. die einzelnen Leiterplatten-Abschnitte 22 sind auf den Leiterplattensegmenten 38 und diese auf den Kunststoff- bzw. Systemträger 21 montiert.

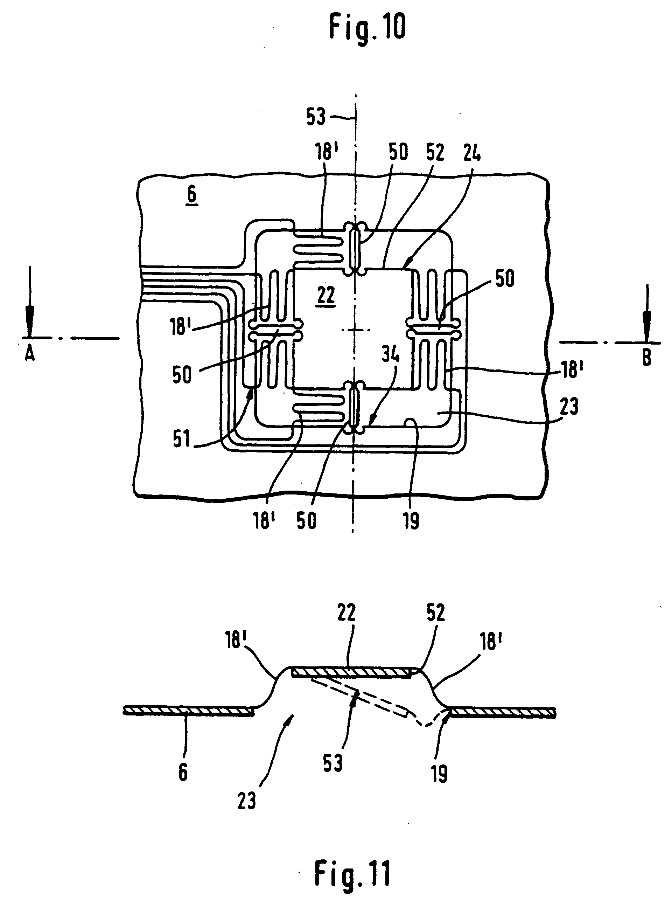

Im Ausführungsbeispiel gemäß Figur 10 weist die Leiterplatte 6 ähnlich wie im Ausführungsbeispiel gemäß Figur 2 eine oder mehrere Ausnehmungen bzw. Ausschnitte 23 auf, die durch eine innere Begrenzung 34 definiert sind. Die Begrenzung 34 entspricht aus der mit 19 gekennzeichnete Stirnkante des Ausschnitts 23. In Figur 10 ist lediglich eine Aussparung 23 dargestellt. Es ist jedoch möglich, mehrere gleichartige Aussparungen 23 in der Leiterplatte 6 vorzusehen. Die Aussparung gemäß Figur 10 ist rechteckförmig ausgebildet. Es ist jedoch auch möglich, die Aussparung 23 quadratisch, kreisförmig, elipsenförmig oder anders geformt auszubilden.

Die rechteckförmige Aussparung 23 dient zur Aufnahme des Leiterplatten-Abschnitts 22, der über im Ausführungsbeispiel gemäß Figur 10 vier Sollbruchstellen 50 mit der entsprechenden gegenüber liegenden Stirnkante 19 der Aussparung 23 fest verbunden ist.

Die Sollbruchstellen 50 können als Montagehilfe vorgesehen werden, damit sich die Leiterplatte 6 mit dem Leiterplatten-Abschnitt 22 für die Montage besser handhaben läßt.

Es ist auch möglich, die Sollbruchstellen 52 nur dann zu trennen bzw. zu lösen, wenn eine übergroße Ausdehnung des Leiterplatten-Abschnitts 22 gegenüber der Leiterplatte 6 stattfindet. Je nach Formgebung und Ausbildung der Leiterplatte 6 ist es beispielsweise möglich, daß lediglich zwei gegenüber liegende Sollbruchstellen 50 getrennt werden, so daß dann gemäß Figur 11 der Leiterplatten-Abschnitt 22 um eine Achse 53 der beiden gegenüberliegenden Sollbruchstellen 50 schwenken kann, die dann weiterhin zur Stabilisierung des Leiterplatten-Abschnitts 22 mit Bezug auf die Leiterplatte 6 innerhalb der Aussparung 23 beitragen.

Neben den einzelnen im Ausführungsbeispiel gemäß Figur 10, vorgesehenen vier Sollbruchstellen 50 sind vier bzw. sechs elektrisch leitende Verbindungselemente 18 vorgesehen, die an die Leiterplatten-Abschnitte 22 angeschlossen sind. Die Verbindungselemente 18 können als Leiterfahnen ausgebildet und mit der Leiterplatte 6 verbunden sein. In vorteilhafter Weise ist es auch möglich, daß die einzelnen Verbindungselemente 18 bzw. Leiterfahnen als Tragelemente fungieren und den Leiterplatten-Abschnitt 22 innerhalb der Aussparung 23 abstützen.

Die einzelnen Verbindungselemente 18 können ein- oder mehrfach gewunden sein bzw. gemäß Figur 10 einen meanderförmigen Verlauf aufweisen, so daß sich der Leiterplatten-Abschnitt 22 gegenüber der Leiterplatte 6 in einem großen Bereich verstellen kann. Der Abstand zwischen der Stirnkante 19 des Ausschnitts 23 und der Stirnkante 52 des Leiterplatten-Abschnitts 22 kann eine Größe aufweisen, der ein Drittel der Gesamtbreite des Leiterplatten-Abschnitts 22 entspricht.

Im Ausführungsbeispiel gemäß Figur 11 befindet sich der Leiterplatten-Abschnitt 22 oberhalb der Aussparung 23. Die in Figur 11 dargestellte Position des Leiterplatten-Abschnitts 22 kann auch als Normallage angesehen werden und zeigt, daß insbesondere in einer Richtung, die quer zur Oberfläche der Leiterplatte 6 verläuft, ein Verstellen des Leiterplatten-Abschnitts 22 möglich ist.

### Bezugszeichenliste

- 1: Kombinations-Instrument
- 2: Anzeigesystem, Bedienelement
- 3: Meßwerk, Anzeigeelement
- 4: Meßwerk, Anzeigeelement
- 5: Meßwerk, Anzeigesystem, Lichtquelle, Zeigerinstrument
- 5': Anzeigedisplay
- 6: Leiterplatte
- 8: Zifferblatt
- 9: Blende
- 10: Zeiger
- 11: Zeiger
- 14: Öffnung, Langlochöffnung
- 14': Öffnung, Langlochöffnung
- 14": Öffnung, Langlochöffnung
- 14'": Öffnung, Langlochöffnung
- 15: Meßmittelpunkt
- 15': Meßmittelpunkt
- 16: Achse, Längsmittelachse
- 17: Ausnehmung, Öffnung
- 18: Verbindungselement
- 18': Verbindungselement bzw. elastische Folie bzw. Ausgleichsschlaufen
- 19: Innenkante, Stirnkante
- 20: Befestigungselement, Schraube, Schraubenbolzen,
- 21: Systemträger bzw. Kombigehäuse zur Aufnahme von Zeigern Anzeigeelementen, bzw. Bedienungselementen
- 22: Leiterplatten-Abschnitt, Unterstützungselemente
- 22': Leiterplatten-Abschnitt
- 23: Ausschnitt, Aussparung
- 24: Begrenzung, Innenkante
- 25: Lichtschacht für die Lichtquelle
- 29: Montageöffnung, Gewindebohrung
- 34: Begrenzung
- 35: Befestigungselement, Zapfen
- 35': Befestigung, Zapfen
- 35': Befestigungselement, Zapfen
- 35": Befestigungselement, Zapfen
- 36: Oberfläche
- 37: Leitkleber
- 38: Unterstützungselement (Leiterplattensegment)
- 39: Nullpunkt = Meßmittelpunkt
- 40: Erweiterung
- 50: Sollbruchstelle
- 51: Windung
- 52: Stirnkante
- 53: Achse

## Patentansprüche

1. Kombinations-Instrument (1) mit einem Gehäuse, einem Systemträger (21) zur Aufnahme von Anzeigeinstrumenten und einer Leiterplatte (6), die mit dem Systemträger (21) mittels Befestigungselementen (35) verbunden ist, **dadurch gekennzeichnet, daß** die Leiterplatte (6) mittels der Befestigungselemente (35) gegenüber dem Systemträger (21) schwimmend gelagert ist und daß die Leiterplatte (6) und/oder der Systemträger (21) in zwei oder mehrere Leiterplatten-Abschnitte (22) bzw. Systemträgerabschnitte aufgeteilt ist, die in mindestens einer Ebene unabhängig voneinander verstellbar sind.

2. Kombinations--Instrument nach Anspruch 1, **dadurch gekennzeichnet, daß** sich die einzelnen Leiterplatten-Abschnitte (22), die mit mindestens einem einzelnen Anzeigeinstrument oder einem einzelnen Display ausgestattet sind, über Verbindungselemente (18) bzw. Tragelemente an Leiterplatten-Abschnitten (22) bzw. an den den Leiterplatten-Abschnitten (22) zugeordneten Teilen abstützen.

3. Kombinations-Instrument nach Anspruch 1 , **dadurch gekennzeichnet, daß** die einzelnen Leiterplatten-Abschnitte (22) über Verbindungselemente (18) bzw. Tragelemente mit benachbarten Leiterplatten-Abschnitten (22) verbunden und unabhängig voneinander gegenüber benachbarten Leiterplatten-Abschnitten (22) und/oder dem Systemträger bzw. Kombigehäuse (21) beweglich sind.

4. Kombinations-Instrument nach Anspruch 1, **dadurch gekennzeichnet, daß** die Verbindungselemente (18) bzw. Tragelemente eine gegenseitige Verstellung der Leiterplatten-Abschnitte (22) zulassen.

5. Kombinations-Instrument nach einem oder mehreren der vorhergehenden Ansprüche, **dadurch gekennzeichnet, daß** die Verbindungselemente (18) bzw. Tragelemente längenveränderlich bzw. elastisch ausgebildet sind.

6. Kombinations-Instrument nach einem der Ansprüche 2 bis 5, **dadurch gekennzeichnet, daß** die Leiterplatte (6) und/oder der Systemträger bzw. das Kombigehäuse (21) einen oder mehrere Ausschnitte aufweisen, in denen die Leiterplatten-Abschnitte (22) und/oder Systemträgerabschnitte eingelassen sind, wobei die Abschnitte zur Aufnahme von Anzeigeelementen und/oder Bedienungselementen dienen.

7. Kombinations-Instrument nach einem oder mehreren der vorhergehenden Ansprüche, **dadurch gekennzeichnet, daß** die äußeren Begrenzungen (24) der in den Ausschnitten (23) aufgenommenen Leiterplatten-Abschnitte (22) allseitig einen annähernd gleichen Abstand zu der die Aussparung (23) bildenden Begrenzung (34) aufweisen.

8. Kombinations-Instrument nach einem oder mehreren der vorhergehenden Ansprüche, **dadurch gekennzeichnet, daß** die in den Ausschnitten (23) aufgenommenen Leiterplatten-Abschnitte (22) über die zahlreichen Verbindungselemente (18) beweglich mit der Leiterplatte (6) verbunden sind.

9. Kombinations-Instrument nach einem oder mehreren der vorhergehenden Ansprüche, **dadurch gekennzeichnet, daß** die Leiterplatte (6) bzw. die Leiterplatten-Abschnitte (22) Öffnungen (14) aufweisen, die auf einer Ebene angeordnet sind, die den Mittelpunkt (15) eines Anzeigesystems bzw. Anzeigedisplays (5,5') schneiden.

10. Kombinations-Instrument nach einem oder mehreren der vorhergehenden Ansprüche, **dadurch gekennzeichnet, daß** die Leiterplatten-Abschnitte zahlreiche Öffnungen (14) aufweisen, die auf zwei oder mehreren sich in einem Winkel (α) schneidenden Achsen (x, y, 16) angeordnet sind, die den Meßmittelpunkt (15) des Meßsystems oder deren Zeigerachse bzw. das Anzeigedisplay (5') oder in etwa den Mittelpunkt des Leiterplatten-Abschnitts (22) schneiden.

11. Kombinations-Instrument nach einem oder mehreren der vorhergehenden Ansprüche, **dadurch gekennzeichnet, daß** das Anzeigesystem (5) bzw. Anzeigedisplay (5') bzw. das Bedienungselement eine Mittelachse (16) aufweist, die senkrecht zu den Öffnungen (14) bzw. parallel zu deren Seitenwänden bzw. der sich durch die Öffnung erstrekkenden Achse (37) verläuft.

12. Kombinations-Instrument nach einem oder mehreren der vorhergehenden Ansprüche, **dadurch gekennzeichnet, daß** die Öffnungen (14) der Leiterplatten-Abschnitte (22) als Langlochöffnungen ausgebildet sind, deren sich in Längsrichtung der Langlochöffnungen (14) erstreckende Längsmittelachsen (16) den Meßmittelpunkt (15) des Meßsystems (5, 5') schneiden oder sich bei mindestens zwei Meßsystemen durch die beiden Meßmittelpunkte (15') erstrecken.

13. Kombinations-Instrument nach einem oder mehreren der vorhergehenden Ansprüche, **dadurch gekennzeichnet, daß** die Verbindungselemente (18) als elektrisch leitende Verbindungselemente (18) ausgebildet sind, die die Leiterplatten (6) miteinander verbinden.

14. Kombinations-Instrument nach einem oder mehreren der vorhergehenden Ansprüche, **dadurch gekennzeichnet, daß** der Systemträger (21) oder die Leiterplatten-Abschnitte (22) zur Aufnahme der Meßsysteme (5) über Zapfen (35) in den Langlochöffnungen (14) beweglich aufgenommen sind.

15. Kombinations-Instrument nach einem oder mehreren der vorhergehenden Ansprüche, **dadurch gekennzeichnet, daß** die Zapfen (35) an einer Seite des Systemträgers (21) angeordnet sind und mit der Oberfläche (36) der Seite des Systemträgers (21) einen rechten Winkel (β) bilden.

16. Kombinations-Instrument nach einem oder mehreren der vorhergehenden Ansprüche, **dadurch gekennzeichnet, daß** die Längsmittelachse (16) zumindest einer im mittleren Bereich der Leiterplatte (6) vorgesehenen Langlochöffnung (14) parallel bzw. in Längsrichtung zur Längsachse (x) der Leiterplatte (6) und die Längsmittelachse (16) zumindest einer weiteren außerhalb des mittleren Bereichs der Leiterplatte (6) vorgesehenen Langlochöffnung (14') parallel bzw. in Längsrichtung zur Querachse (y) der Leiterplatte (6) verläuft.

17. Kombinations-Instrument nach einem oder mehreren der vorhergehenden Ansprüche, **dadurch gekennzeichnet, daß** die Zapfen (35) in etwa mittig in den Langlochöffnungen (14) verschiebbar aufgenommen sind und zur Aufnahme von Schraubenbolzen (20) dienen, über die die einzelnen Leiterplatten-Abschnitte (22) befestigbar sind.

18. Kombinations-Instrument nach einem oder mehreren der vorhergehenden Ansprüche, **dadurch gekennzeichnet, daß** zur Befestigung der Leiterplatte (6), des Zifferblatts (8) und/oder der Bedienungselemente an der Leiterplatte (6) zusätzliche Langlöcher (14") in der Leiterplatte (6) bzw. im Zifferblatt vorgesehen sind, wobei die Längsausrichtung dieser Langlöcher (14") von einem zentralen Nullpunkt (39) der Leiterplatte (6) bzw. des Zifferblatts (8) zum Mittelpunkt des jeweiligen Langlochs (14) erfolgt.

19. Kombinations-Instrument nach einem oder mehreren der vorhergehenden Ansprüche, **dadurch gekennzeichnet, daß** der Nullpunkt (39) der Mittelpunkt (15) des im zentralen Bereich angeordneten, in Querrichtung (y) orientierten Langlochs (14''') ist.

20. Kombinations-Instrument nach einem oder mehreren der vorhergehenden Ansprüche, **dadurch gekennzeichnet, daß** die Leiterplatte (6) und/oder die Anzeigesysteme (5) senkrecht zur Längserstreckung der Öffnungen (14) beweglich gelagert sind.

21. Kombinations-lnstrument nach einem oder mehreren der vorhergehenden Ansprüche, **dadurch gekennzeichnet, daß** die in Aussparungen (23) aufgenommenen Anzeigesysteme (5) senkrecht zur Längserstreckung der Aussparungen (23) angeordnet sind und über nachgiebige Stege mittel- oder unmittelbar mit dem Systemträger (21) verbunden sind.

22. Kombinations-Instrument nach einem oder mehreren der vorhergehenden Ansprüche, **dadurch gekennzeichnet, daß** die Leiterplatte (6) und/oder der Systemträger (21) in zwei oder mehrere Leiterplatten-Abschnitte (22) bzw. Systemträgerabschnitte aufgeteilt sind, die über mindestens ein durchgehendes Verbindungselement (18') miteinander verbunden sind.

23. Kombinations-Inskument nach einem oder mehreren der vorhergehenden Ansprüche, **dadurch gekennzeichnet, daß** das durchgehende Verbindungselement (18') elastisch bzw. als Folie ausgebildet ist.

24. Kombinations-Instrument nach einem oder mehreren der vorhergehenden Ansprüche, **dadurch gekennzeichnet, daß** das durchgehende Verbindungselement (18') aus einem Material besteht, das stärker bzw. leichter verformbar ist als die mit dem Verbindungselement (18') verbundenen Leiterplatten-Abschnitte (22).

25. Kombinations-Instrument nach einem oder mehreren der vorhergehenden Ansprüche, **dadurch gekennzeichnet, daß** das Verbindungselement (18') und der Leiterplatten-Abschnitt (22) aus unterschiedichen Materialien gebildet sind, so daß zwischen dem Verbindungselement (18') und dem Leiterplatten-Abschnitt (22) eine unterschiedlich große Relativausdehnung besteht.

26. Kombinations-Instrument nach einem oder mehreren der vorhergehenden Ansprüche, **dadurch gekennzeichnet, daß** das durchgehende Verbindungselement (18') aus einem Material besteht, das einen größeren Ausdehnungskoeffizienten bzw. eine größere Ausdehnungszahl σ aufweist als der mit dem Verbindungselement (18') verbundene Leiterplatten-Abschnitt (22).

27. Kombinations-Instrument nach einem oder mehreren der vorhergehenden Ansprüche, **dadurch gekennzeichnet, daß** das durchgehende und flexibel ausgebildete Verbindungselement (18') als einteilige Platte bzw. als Folie ausgebildet ist, auf der die einzelnen Leiterplatten-Abschnitte (22) bzw. starren Trägerelemente befestigt sind.

28. Kombinations-Instrument nach einem oder mehreren der vorhergehenden Ansprüche, **dadurch gekennzeichnet, daß** die einzelnen Leiterplatten-Abschnitte (22) bzw. starren Trägerelemente mittels eines Leitklebers (37) fest mit dem Verbindungselement (18') verbunden sind.

29. Kombinations-Instrument nach einem oder mehreren der vorhergehenden Ansprüche, **dadurch gekennzeichnet, daß** der Leitkleber (37) aus einer Isoliermasse mit leitenden Partikeln besteht, die derart in der Isoliermasse aufgenommen sind, daß eine leitende Verbindung zwischen den beiden zu befestigenden Teilen nur in Druckrichtung der gegeneinander gepreßten Teile hergestellt wird.

30. Kombinations-Instrument nach einem oder mehreren der vorhergehenden Ansprüche, **dadurch gekennzeichnet, daß** die einzelnen Leiterplatten-Abschnitte (22) bzw. starren Trägerelemente auf das Verbindungselement (18') geklebt bzw. auflaminiert sind.

31. Kombinations-Instrument nach einem oder mehreren der vorhergehenden Ansprüche, **dadurch gekennzeichnet, daß** das Verbindungselement (18') um seine Längsmittelachse und/oder zwischen den zu verbindenden Teilen um seine Querachse in einem bestimmten Winkelbereich verdrehbar ist.

32. Kombinations-Instrument nach einem oder mehreren der vorhergehenden Ansprüche, **dadurch gekennzeichnet, daß** das Verbindungselement (18') bei Temperaturschwankungen zwischen den einzelnen Leiterplatten-Abschnitten (22) ausbeulbar ist.

33. Kombinations-Instrument nach einem oder mehreren der vorhergehenden Ansprüche, **dadurch gekennzeichnet, daß** die Leiterplatte (6) als flexible durchgehende Platte bzw. als Folie ausgebildet ist, die auf mehreren mit Abstand zueinander angeordneten Unterstützungselementen (38) aufgebracht bzw. mit diesen verklebt ist.

34. Kombinations-Instrument nach einem oder mehreren der vorhergehenden Ansprüche, **dadurch gekennzeichnet, daß** die flexible Leiterplatte (6) über als Verbindungselemente ausgebildete Ausgleichsschlaufen (18) mit den Leiterplatten-Abschnitten (22) verbunden und auf dem Kunststoff- bzw. Systemträger (21) montiert ist.

35. Kombinations-Instrument (1) nach Anspruch 1 **dadurch gekennzeichnet, daß** die Leiterplatte (6) und/oder der Systemträger (21) in zwei oder mehrere Leiterplatten-Abschnitte (22) bzw. Systemträgerabschnitte aufgeteilt sind, die in mehreren Ebenen unabhängig voneinander verstellbar sind.

36. Kombinations-Instrument (1) nach Anspruch 1 **dadurch gekennzeichnet, daß** die Leiterplatten-Abschnitte (22) in der Ebene, quer zur Ebene und/oder schräg zur Ebene der Leiterplatte (6) verstellbar sind.

37. Kombinations-Instrument (1) nach Anspruch 1, **dadurch gekennzeichnet, daß** die Leiterplatten-Abschnitte (22) über eine oder mehrere Sollbruchstellen (50) mit der Leiterplatte (6) verbunden sind.

38. Kombinations-Instrument (1) nach Anspruch 1 **dadurch gekennzeichnet, daß** die Leiterplatten-Abschnitte (22) über eine oder mehrere Windungen (51) aufweisende Verbindungselemente (18) mit der Leiterplatte (6) verbunden sind.

39. Kombinations-Instrument (1) nach Anspruch 1 **dadurch gekennzeichnet, daß** die Leiterplatten-Abschnitte (22) über ein oder mehrere meanderförmig verlaufende Verbindungselemente (18) mit der Leiterplatte (6) verbunden sind.

40. Kombinations-Instrument (1) nach Anspruch 1 **dadurch gekennzeichnet, daß** die Verbindungselemente (18) zwischen den Leiterplatten-Abschnitten (22) und der Leiterplatte (6) als elektrisch leitende und/oder als elektrisch nicht leitende Verbindungselemente ausgebildet sind.

41. Kombinations-Instrument (1) nach Anspruch 1 **dadurch gekennzeichnet, daß** die Leiterplatten-Abschnitte (22) rechteckförmig oder quadratisch ausgebildet sind und jede Stirnkante (52) bzw. der an die Stirnkante angrenzende Bereich des Leiterplatten-Abschnitts (22) innerhalb der den Leiterplatten-Abschnitt (22) aufnehmenden Aussparung (23) der Leiterplatte (6) über ein oder zwei Verbindungselemente (18) mit der Leiterplatte (6) beweglich verbunden ist.

42. Kombinations-Instrument (1) nach Anspruch 1 **dadurch gekennzeichnet, daß** jedem Verbindungselement (18) eine Sollbruchstelle (50) zugeordnet ist.

43. Kombinations-Instrument (1) nach Anspruch 1 **dadurch gekennzeichnet, daß** jede Stirnkante (52) des Leiterplatten-Abschnitts (22) über die Sollbruchstelle (50) mit der parallel zur Stirnkante (52) des Leiterplatten-Abschnitts (22) verlaufenden Stirnkante (19) der Aussparung (23) verbunden ist.

44. Kombinations-Instrument (1) nach Anspruch 1 **dadurch gekennzeichnet, daß** bei großer Wärmeausdehnung jeweils die beiden gegenüberliegenden Sollbruchstellen (50) gelöst werden und sich der Leiterplatten-Abschnitt (22) um die Achse der beiden verbleibenden, gegenüberliegenden Sollbruchstellen neigt.

## Claims

1. Combination instrument (1) having a housing, having a system mount (21) for holding indicating instruments and having a printed circuit (6) which is connected to the system mount (21) by means of a attachment elements (35), **characterized in that** the printed circuit (6) is mounted by means of the attachment elements (35) such that it can float with respect to the system mount (21), and **in that** the printed circuit (6) and/or the system mount (21) is subdivided into two or more printed circuit sections (22) and/or system mount sections which can be moved independently of one another in at least one plane.

2. Combination instrument according to Claim 1, **characterized in that** the individual printed circuit sections (22), which are equipped with at least one individual indicating instrument or one individual display, are supported via connecting elements (18) on printed circuit sections (22), and/or are supported via mounting elements on the parts which are associated with the printed circuit sections (22).

3. Combination instrument according to Claim 1, **characterized in that** the individual printed circuit sections (22) are connected via connecting elements (18) and/or mounting elements to adjacent printed circuit sections (22) and can move independently of one another with respect to adjacent printed circuit sections (22) and/or with respect to the system mount or combination housing (21).

4. Combination instrument according to Claim 1, **characterized in that** the connecting elements (18) and/or mounting elements allow mutual adjustment of the printed circuit sections (22).

5. Combination instrument according to one or more of the preceding claims, **characterized in that** the connecting elements (18) have variable lengths, and the mounting elements are elastic.

6. Combination instrument according to one of Claims 2 to 5, **characterized in that** the printed circuit (6) and/or the system mount or the combination housing (21) has/have one or more cutouts, into which the printed circuit sections (22) and/or the system mount sections are inserted, with the sections being used to hold indicating elements and/or control elements.

7. Combination instrument according to one or more of the preceding claims, **characterized in that** the outer boundaries (24) of the printed circuit sections (22) which are held in the cutouts (23) are at approximately the same distance on all sides from the boundary (34) which forms the cutout (23).

8. Combination instrument according to one or more of the preceding claims, **characterized in that** the printed circuit sections (22) which are held in the cutouts (23) are connected to the printed circuit (6) via the numerous connecting elements (18) such that they can move.

9. Combination instrument according to one or more of the preceding claims, **characterized in that** the printed circuit (6) and/or the printed circuit sections (22) has/have openings (14) which are arranged on a plane which intersects the centre point (15) of an indicating system or indicating display (5, 5').

10. Combination instrument according to one or more of the preceding claims, **characterized in that** the printed circuit sections have numerous openings (14) which are arranged on two or more axes (x, y, 16) which intersect at an angle (α) and intersect the measurement centre point (15) of the measurement system, or its pointer axis, and/or intersect the indicating display (5'), and/or intersect approximately at the centre point of the printed circuit section (22).

11. Combination instrument according to one or more of the preceding claims, **characterized in that** the indicating instrument (5) and/or the indicating display (5') and/or the control element have/has a centre axis (16) which runs at right angles to the openings (14) and/or parallel to its side walls and/or to the axis (37) which extends through the opening.

12. Combination instrument according to one or more of the preceding claims, **characterized in that** the openings (14) in the printed circuit sections (22) are in the form of elongated hole openings, whose longitudinal centre axes (16), which extend in the longitudinal direction of the elongated hole openings (14), intersect the measurement centre point (15) of the measurement system (5, 5') or, when there are at least two measurement systems, extend through the two measurement centre points (15').

13. Combination instrument according to one or more of the preceding claims, **characterized in that** the connecting elements (18) are in the form of electrically conductive connecting elements (18) which connect the printed circuits (6) to one another.

14. Combination instrument according to one or more of the preceding claims, **characterized in that** the system mount (21) or the printed circuit sections (22) is/are held via pins (35) in the elongated hole openings (14) such that they can move, in order to hold the measurement systems (5).

15. Combination instrument according to one or more of the preceding claims, **characterized in that** the pins (35) are arranged on one face of the system mount (21) and form a right angle (β) with the surface (36) of that face of the system mount (21).

16. Combination instrument according to one or more of the preceding claims, **characterized in that**, at least in one elongated hole opening (14) which is provided in the central area of the printed circuit (6), the longitudinal centre axis (16) runs parallel to or in the longitudinal direction of the longitudinal axis (x) of the printed circuit (6), and the longitudinal centre axis (16) of at least one further elongated hole opening (14'), which is provided away from the central area of the printed circuit (6), runs parallel to or in the longitudinal direction of the lateral axis (y) of the printed circuit (6).

17. Combination instrument according to one or more of the preceding claims, **characterized in that** the pins (35) are held approximately centrally in the elongated hole openings (14) such that they can move and are used for holding threaded bolts (20) via which the individual printed circuit sections (22) can be attached.

18. Combination instrument according to one or more of the preceding claims, **characterized in that** additional elongated holes (14'') are provided in the printed circuit (6) and/or in the dial for attachment of the printed circuit (6), of the dial (8) and/or of the control elements to the printed circuit (6), with these elongated holes (14'') being aligned longitudinally from a centre zero point (39) of the printed circuit (6) and/or of the dial (8) to the centre point of the respective elongated hole (14).

19. Combination instrument according to one or more of the preceding claims, **characterized in that** the zero point (39) is the centre point (15) of the elongated hole (14''') which is arranged in the central area and is oriented in the lateral direction (y).

20. Combination instrument according to one or more of the preceding claims, **characterized in that** the printed circuit (6) and/or the indicating systems (5) are/is mounted such that they/it can move at right angles to the longitudinal extent of the openings (14).

21. Combination instrument according to one or more of the preceding claims, **characterized in that** the indicating systems (5) which are held in cutouts (23) are arranged at right angles to the longitudinal extent of the cutouts (23) and are connected indirectly via flexible webs or directly to the system mount (21).

22. Combination instrument according to one or more of the preceding claims, **characterized in that** the printed circuit (6) and/or the system mount (21) are/is subdivided into two or more printed circuit sections (22) and system mount sections, respectively, which are connected to one another via at least one connecting element (18') which passes all the way through.

23. Combination instrument according to one or more of the preceding claims, **characterized in that** the connecting element (18') which passes all the way through is elastic or in the form of a film.

24. Combination instrument according to one or more of the preceding claims, **characterized in that** the connecting element (18') which passes all the way through is composed of a material which is harder or easier to deform than the printed circuit sections (22) which are connected to the connecting element (18').

25. Combination instrument according to one or more of the preceding claims, **characterized in that** the connecting element (18') and the printed circuit section (22) are formed from different materials, so that different relative expansion occurs between the connecting element (18') and the printed circuit section (22).

26. Combination instrument according to one or more of the preceding claims, **characterized in that** the connecting element (18') which passes all the way through is composed of a material which has a greater coefficient of expansion σ than the printed circuit section (22) which is connected to the connecting element (18').

27. Combination instrument according to one or more of the preceding claims, **characterized in that** the connecting element (18') which passes all the way through and is designed to be flexible is in the form of an integral panel or a film, on which the individual printed circuit sections (22) or rigid mount elements are mounted.

28. Combination instrument according to one or more of the preceding claims, **characterized in that** the individual printed circuit sections (22) and/or rigid mount elements are firmly connected to the connecting element (18') by means of a conductive adhesive (37).

29. Combination instrument according to one or more of the preceding claims, **characterized in that** the conductive adhesive (37) is composed of an insulating compound with conductive particles, which are held in the insulating compound such that a conductive connection is produced between the two parts to be attached only in the compression direction of the parts which are pressed against one another.

30. Combination instrument according to one or more of the preceding claims, **characterized in that** the individual printed circuit elements (22) are bonded onto the connecting element (18'), and the rigid mount elements are laminated onto the connecting element (18').

31. Combination instrument according to one or more of the preceding claims, **characterized in that** the connecting element (18') can rotate in a specific angular range about its longitudinal centre axis, and/or between the parts to be connected about its lateral axis.

32. Combination instrument according to one or more of the preceding claims, **characterized in that** the connecting element (18') can buckle between the individual printed circuit sections (22) in the event of temperature fluctuations.

33. Combination instrument according to one or more of the preceding claims, **characterized in that** the printed circuit (6) is in the form of a flexible panel which passes all the way through or is in the form of a film, which panel or film is fitted to, and/or is adhesively bonded to, a number of supporting elements (38) which are arranged at a distance from one another.

34. Combination instrument according to one or more of the preceding claims, **characterized in that** the flexible printed circuit (6) is connected to the printed circuit sections (22), and is mounted on the plastic or system mount (21), via expansion loops (18) which are in the form of connecting elements.

35. Combination instrument (1) according to Claim 1, **characterized in that** the printed circuit (6) and/or the system mount (21) is/are subdivided into two or more printed circuit sections (22) or system mount sections, respectively, which can be moved independently of one another in a number of planes.

36. Combination instrument (1) according to Claim 1, **characterized in that** the printed circuit sections (22) can be moved in the plane transversely with respect to the plane and/or obliquely with respect to the plane of the printed circuit (6).

37. Combination instrument (1) according to Claim 1, **characterized in that** the printed circuit sections (22) are connected to the printed circuit (6) via one or more weak points (50).

38. Combination instrument (1) according to Claim 1, **characterized in that** the printed circuit sections (22) are connected to the printed circuit (6) via connecting elements (18) which have one or more turns (51).

39. Combination instrument (1) according to Claim 1, **characterized in that** the printed circuit sections (22) are connected to the printed circuit (6) via one or more meandering connection elements (18).

40. Combination instrument (1) according to Claim 1, **characterized in that** the connecting elements (18) between the printed circuit sections (22) and the printed circuit (6) are in the form of electrically conductive connecting elements and/or electrically nonconductive connecting elements.

41. Combination instrument (1) according to Claim 1, **characterized in that** the printed circuit sections (22) are rectangular or cuboid and each end edge (52), and/or the area of the printed circuit section (22) which is adjacent to the end edge, within the cutout (23) which holds the printed circuit section (22) in the printed circuit (6) are/is connected to the printed circuit (6) via one or two connecting elements (18) such that they/it can move.

42. Combination instrument (1) according to Claim 1, **characterized in that** each connecting element (18) has an associated weak point (50).

43. Combination instrument (1) according to Claim 1, **characterized in that** each end edge (52) of the printed circuit section (22) is connected via the weak point (50) to that end edge (19) of the cutout (23) which runs parallel to the end edge (52) of the printed circuit section (22).

44. Combination instrument (1) according to Claim 1, **characterized in that**, if major thermal expansion occurs, the two mutually opposite weak points (50) are each detached, and the printed circuit section (22) tilts about the axis of the two remaining, mutually opposite weak points.

## Revendications

1. Instruments combinés (1) comportant un boîtier, un porte-système (21) pour recevoir des instruments indicateurs et ùne carte à circuit imprimé (6) qui est reliée au porte-système (21) au moyen d'éléments de fixation (35), **caractérisés par le fait que** la carte à circuit imprimé (6) est, au moyen des éléments de fixation (35), portée flottante par rapport au porte-système (21) et quc la carte à circuit imprimé (6) et/ou le porte-système (21) sont divisés en dcux, ou davantage, portions de carte à circuit imprimé (22) ou portions de porte-système qui peuvent se déplacer indépendamment l'unc de l'autre au moins dans un plan.

2. Instruments combinés selon la revendication 1, **caractérisés par le fait que** les différentes portions (22) de carte à circuit imprimé, qui sont équipées d'au moins un seul instrument indicateur ou un seul visuel, s'appuient, par l'intermédiaire d'éléments de liaison (18) ou d'éléments supports, sur des portions (22) de carte à circuit imprimé ou sur les parties correspondant aux portions (22) dé carte à circuit imprimé.

3. Instruments combinés selon la revendication 1, ----, **caractérisés par le fait que** les différentes portions (22) de carte à circuit imprimé sont reliées, par l'intermédiaire d'éléments de liaison (18) ou d'élémcnts porteurs, aux portions (22) de carte à circuit imprimé voisines et sont mobiles, indépendamment l'une de l'autre, par rapport aux portions (22) de carte à circuit imprimé voisines et/ou au porte-système ou au bottier (21) des instruments combinés.

4. Instruments combinés selon la revendication 1, **caractérisés par le fait que** les éléments de liaison (18) ou élémcnts porteurs autorisent un déplacement mutuel des portions (22) de carte à circuit imprimé.

5. Instruments combinés selon l'une ou plusieurs des revendications précédentes, **caractérisés par le fait que** les éléments de liaison (8) ou éléments portcurs sont conçus de longueur variable ou élastique.

6. Instruments combinés selon l'une des revendications 2 à 5, **caractérisés par le fait que** la carte à carte à circuit imprimé (6) et/ou le porte-système ou le boîtier (21) des instruments combinés présentent une ou plusieurs découpes dans lesquelles sont insérées les portions (22) de carie à circuit imprimé et/ou des portions de porte-système, les portions servant à recevoir des éléments indicateurs et/ou des éléments de service.

7. Instruments combinés selon l'une ou plusieurs des revendications précédentes, **caractérisés par le fait que** les limites extérieures (24) des portions (22) de carte à circuit imprimé insérées dans les découpes (23) présentent, de tous côtés, une distance approximativement égale à la limite formant l'évidement (23).

8. Instruments combinés selon l'une ou plusieurs des revendications précédentes, **caractérisés par le fait que** les portions (22) de carte à circuit imprimé insérées dans les découpes (23) sont, par l'intermédiaire des nombreux éléments de liaison (8), reliées à la carte à circuit imprimé (6) avec une certaine mobilité.

9. Instruments combinés selon l'une ou plusieurs des revendications précédentes, **caractérisés par le fait que** la carte à circuit imprimé (6) ou les portions (22) de carte à circuit imprimé présentent des ouvertures (14) qui sont disposées dans un plan qui passe par le point médian (15) d'un système indicateur ou d'un visuel (5, 5').

10. Instruments combinés selon l'une ou plusieurs des revendications précédentes, **caractérisés par le fait que** les portions de carte à circuit imprimé présentent de nombreuses ouvertures (14) qui sont disposées sur deux, ou davantage, axes (x, y, 16) qui s'intersectent sous un angle (α) et qui passent par le point médian (15) du système de mesure ou par l'axe de son aiguille ou par le visuel (5') ou à peu prés par le point médian de la portion (22) de carte à circuit imprimé.

11. Insíruments Instruments combinés selon l'une ou plusieurs des revendications précédentes, **caractérisés par le fait que** le système indicateur (5) ou le visuel (5') ou l'élément de service présente un axe médian (16) qui est orienté perpendiculairement aux ouvertures (14) ou parallèlement à leurs parois latérales ou à l'axe (37) qui passe par l'ouverture.

12. Instruments combinés selon l'une ou plusieurs des revendications précédentes, **caractérisés par le fait que** les ouvertures (14) des portions (22) de carte à circuit imprimé sont conçues sous forme de lumières dont des axes médians longitudinaux (16), s'étendant selon la direction longitudinale des lumières (14), passent par le point médian (15) du système de mesure (5, 5') ou, dans le cas d'au moins deux systèmes de mesure, passent par les deux points médians (15').

13. Instruments combinés selon l'une ou plusieurs des revendications précédentes, **caractérisés par le fait que** les éléments de liaison (18) sont conçus sous forme d'éléments de liaison (8) électriquement conducteurs qui relient entre elles les cartes à circuit imprimé (6).

14. Instruments combinés selon l'une ou plusieurs des revendications précédentes, **caractérisés par le fait que** le porte-système (21) ou les portions (22) de carte à circuit imprimé prévus pour recevoir les systèmes de mesure (5) sont, par l'intermédiaire de tétons (35), reçus dans les lumières (14) avec unc certaine mobilité.

15. Instruments combinés selon l'une ou plusieurs des revendications précédentes, **caractérisés par le fait que** les tétons (35) sont disposés d'un côté du porte-système (21) et font un angle droit (β) avec la surface (36) de la face du porte-système (21).

16. Instruments combinés selon l'une ou plusieurs des revendications précédentes, **caractérisés par le fait que** l'axe longitudinal médian (16) d'au moins une lumière (14) prévue dans la zone médiane de la carte à circuit imprimé (6) est orienté parallèlement ou selon la direction longitudinale par rapport à l'axe longitudinal (x) de la carte à circuit imprimé (6) et que l'axe longitudinal médian (16) d'au moins une autre lumière (14'), prévue à l'extérieur de la zone médiane de la carte à circuit imprimé (6), est orienté parallèlement ou selon la direction longitudinale par rapport à l'axe transversal (y) de la carte à circuit imprimé (6).

17. Instruments combinés selon l'une ou plusieurs des revendications précédentes, **caractérisés par le fait que** les tétons (35) sont reçus, avec possibilité de coulisser, à peu prés au centre des lumières (14) et servent à recevoir des vis (20) au moyen desquelles les différentes portions (22) de carte à circuit imprimé peuvent être fixées.

18. Instruments combinés selon l'une ou plusieurs des revendications précédentes, **caractérisés par le fait que** pour la fixation de la carte à circuit imprimé (6), du cadran (8) et/ou des éléments de service sur la carte à circuit imprimé (6), des lumières supplémentaires (14") sont prévues sur la carte à circuit imprimé (6) ou sur le cadran, l'orientation longitudinale de ces lumières (14") se faisant d'un point zéro central (39) de la carte à circuit imprimé (6) ou du cadran (8) vers le point médian de la lumière respective (14).

19. Instruments combinés selon l'une ou plusieurs des revendications précédentes, **caractérisés par le fait que** le point zéro (39) est le point médian (15) de la lumière (14"') disposée dans la zone centrale et orientée selon la direction transversale (y).

20. Instruments combinés selon l'une ou plusieurs des revendications précédentes, **caractérisés par le fait que** la carte à circuit imprimé (6) et/ou les systèmes indicateurs (5) sont portés avec une certaine mobilité perpendiculairement à l'extension longitudinale des lumières (14).

21. Instruments combinés selon l'une ou plusieurs des revendications précédentes, **caractérisés par le fait que** les systèmes indicateurs (5) reçus dans les évidements (23) sont disposés perpendiculairement à l'extension longitudinale des évidements (23) et sont, au moyen de barrettes pouvant céder, indirectement ou directement reliés au porte-système (21).

22. Instruments combinés sclon l'une ou plusieurs des revendications précédentes, **caractérisés par le fait que** la carte à circuit imprimé (6) et/ou le porte-système (21) sont divisés en deux, ou davantage, portions (22) de carte à circuit imprimé ou portions de porte-système qui sont reliées l'une à l'autre par l'intermédiaire d'au moins un élément de liaison continu (18').

23. Instruments combinés selon l'une ou plusieurs des revendications précédentes, **caractérisés par le fait que** l'élément de liaison continu (18') est élastique ou est conçu sous forme d'une feuille.

24. Instruments combinés selon l'une ou plusieurs des revendications précédentes, **caractérisés par le fait que** l'élément de liaison continu (18') est constitué d'un matériau qui peut se déformer plus fortement ou plus facilement que les portions (22) de carte à circuit imprimé reliées à l'élément de liaison (18').

25. instruments combinés selon l'une ou plusieurs des revendications précédentes, **caractérisés par le fait que** l'élément de liaison (18') et la portion (22) de carte à circuit imprimé sont formés de matériaux différents de sorte qu'entre l'élément de liaison (18') et la portion (22) de carte à circuit imprimé il y a une dilatation relative de valeur différente.

26. Instruments combinés selon l'une ou plusieurs des revendications précédentes, **caractérisés par le fait que** l'élément de liaison continu (18') est constitué d'un matériau qui présente un plus grand coefficient de dilatation ou un plus grand indice de dilatation σ que la portion (22) de carte à circuit imprimé reliée à l'élément de liaison (18').

27. Instruments combinés selon l'une ou plusieurs des revendications précédentes, **caractérisés par le fait que** l'élément de liaison (18'), continu et prévu flexible, est conçu sous forme d'une plaque d'une seule pièce ou d'une feuille sur laquelle sont fixés les différentes portions (22) de carte à circuit imprimé ou les éléments porteurs rigides.

28. Instruments combinés selon l'une ou plusieurs des revendications précédentes, **caractérisés par le fait que** les différentes portions (22) de carte à circuit imprimé ou les éléments porteurs rigides sont solidarisés avec l'élément de liaison (18') au moyen d'une colle conductrice (37).

29. Instruments combinés selon l'une ou plusieurs des revendications précédentes, **caractérisés par le fait que** la colle conductrice (37) est constituée d'une masse isolante avec des particules conductrices qui sont reçues dans la masse isolante de façon qu'une liaison conductrice entre les deux pièces à fixer ne soit réalisée que dans la direction de la mise sous pression des pièces, pressées l'une contre l'autre.

30. Instruments combinés selon l'une ou plusieurs des revendications précédentes, **caractérisés par le fait que** les différentes portions (22) de carte à circuit imprimé ou éléments supports rigides sont collés ou stratifiés sur l'élément de liaison (18').

31. Instruments combinés selon l'une ou plusieurs des revendications précédentes, **caractérisés par le fait que** l'élément de liaison (18') peut tourner sur une plage angulairc déterminée autour de son axe longitudinal médian et/ou entre les parties à relier, autour de son axe transversal.

32. Instruments combinés selon l'une ou plusieurs des revendications précédentes, **caractérisés par le fait qu'**en cas de variation de la température, l'élément de liaison (18') peut se voiler entre les différentes portions (22) de carte à circuit imprimé.

33. Instruments combinés selon l'une ou plusieurs des revendications précédentes, **caractérisés par le fait que** la carte à circuit imprimé (6) est conçue sous forme de carte flexible continue ou de feuille appliquée sur plusieurs éléments d'appui disposés à une certaine distance l'un de l'autre ou collée avec ces éléments d'appui.

34. Instruments combinés selon l'une ou plusieurs des revendications précédentes, **caractérisés par le fait que** la carte à circuit imprimé flexible (6) est reliée aux portions (22) de carte à circuit imprimé par l'intermédiaire de boucles de compensation (18) conçues comme éléments de liaison et est montée sur le support plastique ou le porte-système (21).

35. Instruments combinés (1) selon la revendication 1, **caractérisés par le fait que** la carte à circuit imprimé (6) et/ou le porte-système (21) sont divisés en deux, ou davantage, portions (22) de carte à circuit imprimé ou portions de porte-système qui peuvent se déplacer dans plusieurs plans indépendamment l'une de l'autre.

36. Instruments combinés (1) selon la revendication 1, **caractérisés par le fait que** les portions (22) de carte à circuit imprimé peuvent se déplacer dans le plan, transversalement par rapport au plan et/ou obliquement par rapport au plan de la carte à circuit imprimé (6).

37. Instruments combinés (1) selon la revendication 1, **caractérisés par le fait que** les portions (22) de carte à circuit imprimé sont reliées à la carte à circuit imprimé (6) par l'intermédiaire d'une ou plusieurs positions de rupture préférentielle (50).

38. Instruments combinés (1) selon la revendication 1, **caractérisés par le fait que** les portions (22) de carte à circuit imprimé sont reliées à la carte à circuit imprimé (6) par l'intermédiaire d'éléments de liaison (18) présentant une ou plusieurs boucles (51).

39. Instruments combinés (1) selon la revendication 1, **caractérisés par le fait que** les portions (22) de carte à circuit imprimé sont reliées à la carte à circuit imprimé (6) par l'intermédiaire d'un ou plusieurs éléments de liaison (18) formant des méandres.

40. Instruments combinés (1) selon la revendication 1, caractérlsés par le fait que les éléments de liaison (18) entre les portions (22) de carte à circuit imprimé et la carte à circuit imprimé (6) sont conçus sous forme d'éléments de liaison électriquement conducteurs et/ou électriquement non conducteurs.

41. Instruments combinés (1) selon la revendication 1, **caractérisés par le fait que** les portions (22) de carte à circuit imprimé sont de forme rectangulaire ou carrée et que chaque bord frontal (52) ou la zone de la portion (22) de carte à circuit imprimé qui jouxte le bord frontal, est, à l'intérieur de l'évidement (23) de la carte à circuit imprimé (6) qui reçoit la portion (22) de carte à circuit imprimé, relié, avec une certaine mobilité à la carte à circuit imprimé (6) par l'intermédiaire d'un ou de deux élémcnts de liaison (18).

42. Instruments combinés (1) selon la revendication 1, **caractérisés par le fait qu'**à chaque élément de liaison (18) est associée une position de rupture préférentielle (50).

43. Instruments combinés (1) selon la revendication 1, **caractérisés par le fait que** chaque bord frontal (52) de la portion (22) de carte à circuit imprimé est relié, par l'intermédiaire de la position de rupture préférentielle (50), avec le bord frontal (19) de l'évidement (23) orienté parallèlement au bord frontal (52) de la portion (22) de carte à circuit imprimé.

44. Instruments combinés (1) selon la revendication 1, **caractérisés par le fait que** dans le cas d'une importante dilatation thermique chacune des deux positions de rupture préférentielle (50) situées en face l'une de l'autre se rompent et que la portion (22) de carte à circuit imprimé s'incline autour de l'axe des deux positions de rupture préférentielle subsistantes, situées en face l'une de l'autre.
